# EUROPEAN PATENT SPECIFICATION

(11) **EP 4 365 946 B1**
(45) Date of publication and mention of the grant of the patent: **11.02.2026**
(21) Application number: 23199710.7
(22) Date of filing: 26.09.2023
(51) Int. Cl.: H01L 25/065, H01L 21/78, H01L 23/485, H01L 21/98, H10F 39/00

(54) **METHOD OF MANUFACTURING A SEMICONDUCTOR DEVICE**
VERFAHREN ZUR HERSTELLUNG EINER HALBLEITERANORDNUNG
PROCÉDÉ DE FABRICATION D'UN DISPOSITIF SEMI-CONDUCTEUR

(30) Priority: 01.11.2022 KR 20220143540
(43) Date of publication of application: 08.05.2024
(73) Proprietor: Samsung Electronics Co., Ltd., Suwon-si, Gyeonggi-do 16677 (KR)
(72) Inventor: CHOO, Gyosoo, 16677 Suwon-si (KR); BYEON, Daeseok, 16677 Suwon-si (KR); KWON, Taehong, 16677 Suwon-si (KR)
(74) Representative: Marks & Clerk LLP

(56) References cited:
- US-A1- 2007 023 121
- US-A1- 2015 311 183
- US-A1- 2022 238 751

## Description

### 1 FIELD

The present invention relates to a method of manufacturing a semiconductor device.

### 2. RELATED ART

An electronic system requiring data storage needs a high capacity semiconductor device that may store high capacity data. Methods of increasing the data storage capacity of the semiconductor device have been studied. For example, a semiconductor device including memory cells that may be three-dimensionally stacked has been suggested.

As the number of memory cells stacked in a vertical direction increases, a substrate on which the semiconductor device is formed may be bent, and the electric characteristics of the semiconductor device may be deteriorated.

US2007/0023121A1 discloses a method of assembling an electronic device including dividing a first wafer into a set of panels, and bonding a panel to a panel site of a second wafer to form a panel stack.

In details, this document discloses:
A method of manufacturing a semiconductor device, the method comprising:
forming, on a first wafer, a first structure including first chip regions and a first scribe lane region surrounding the first chip regions;
forming, on a second wafer, a second structure including second chip regions and a second scribe lane region surrounding the second chip regions;
separating a first part of the second wafer by a first dicing process, the first part of the second wafer including first ones of the second chip regions in the central portion of the second wafer in a plan view, the first dicing process performed along a portion of the second scribe lane region surrounding the first part;
bonding the first part of the second wafer with the first wafer;
separating at least one second part of the second wafer by a second dicing process, each of the at least one second part including second ones of the second chip regions in at least one edge portion of the second wafer in a plan view, the second ones of the second chip regions being other than the first ones of the second chip regions, the second dicing process performed along a portion of the second scribe lane region surrounding each of the at least one second part;
bonding the at least one second part of the second wafer with the first wafer thereby bonding the second ones of the second chip regions with the first wafer;
separating the first wafer bonded with the first part and the at least one second part of the second wafer into a plurality of chips each including one of the first chip regions of the first wafer and one of the second chip regions of the second wafer by a third dicing process, wherein a warpage occurrence probability of the central portion of the second wafer is lower than a warpage occurrence of the at least one edge portion of the second wafer.

US2015/0311183A1 discloses a method of manufacturing a package structure. A package step is carried out to package an array chip onto a wafer so as to electrically connect a first die and a second die. US2022/0238751A1 discloses a method of manufacturing a micro-light-emitting diode display.

### SUMMARY

The invention provides a method of manufacturing a semiconductor device as set out in the appended claims. Example embodiments provide a method of manufacturing a semiconductor device having improved characteristics as defined in the appended claims.

### BRIEF DESCRIPTION OF DRAWINGS

FIGS. 1 to 28 are plan views and cross-sectional views illustrating a method of manufacturing a semiconductor device in accordance with example embodiments.
FIGS. 29A, 29B and 29C illustrate plan views illustrating a shape of the first portion 900 of the second substrate 700 separated from the second substrate 700 by the first dicing process in accordance with example embodiments.
FIGS. 30 to 32 includes plan views illustrating positions and layouts of the first portion 900 of the second substrate 700 separated from the second substrate 700 by the first dicing process in accordance with example embodiments, which do not form part of the claimed invention.
FIGS. 33 to 52 are plan views and cross-sectional views illustrating a method of manufacturing a CMOS image sensor (CIS) in accordance with example embodiments.

### DETAILED DESCRIPTION

Hereinafter, a semiconductor device, a method for manufacturing the same, and a mass data storage system including the semiconductor device in accordance with example embodiments will be described in detail with reference to the accompanying drawings. It will be understood that, although the terms "first," "second," and/or "third" may be used herein to describe various elements, these elements should not be limited by these terms. These terms are only used to distinguish one element from another element. Each example embodiment provided in the following description is not excluded from being associated with one or more features of another example or another example embodiment also provided herein or not provided herein but consistent with the present disclosure. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. As used herein, the term "and/or' includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. It will be also understood that, even if a certain step or operation of manufacturing an apparatus or structure is described later than another step or operation, the step or operation may be performed later than the other step or operation unless the other step or operation is described as being performed after the step or operation.

As used herein, a vertical direction substantially perpendicular to an upper surface of a substrate may be referred to as a first direction DI, and two directions crossing each other among horizontal directions substantially parallel to the upper surface of the substrate may be referred to as second and third directions D2 and D3, respectively. In example embodiments, the second and third directions may be substantially perpendicular to each other.

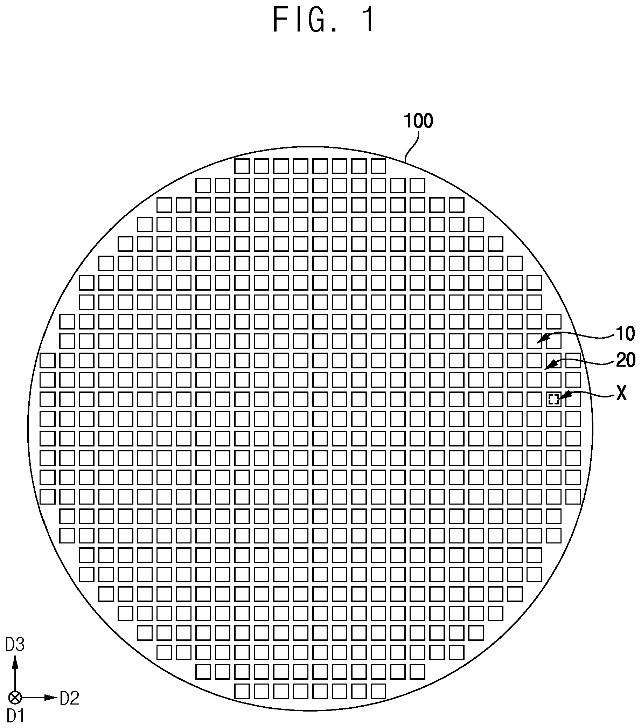

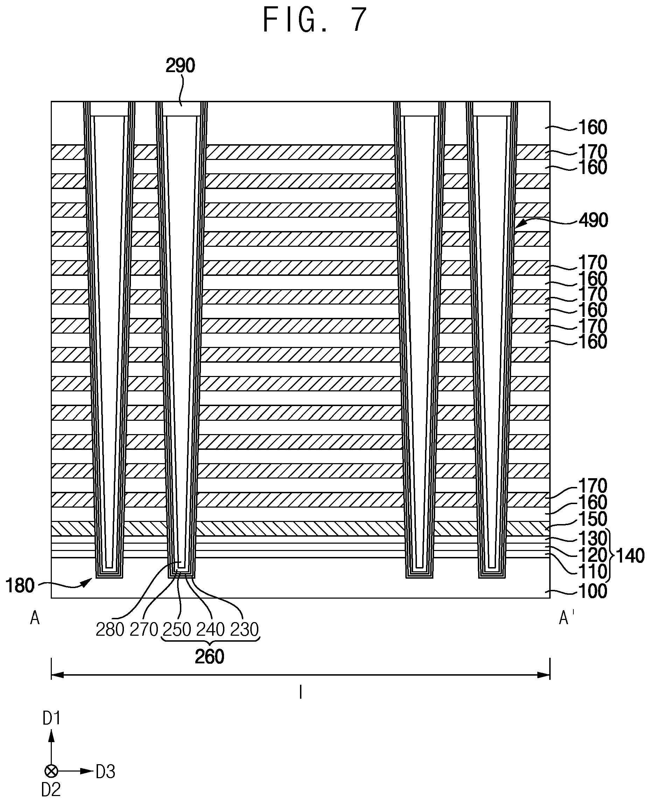

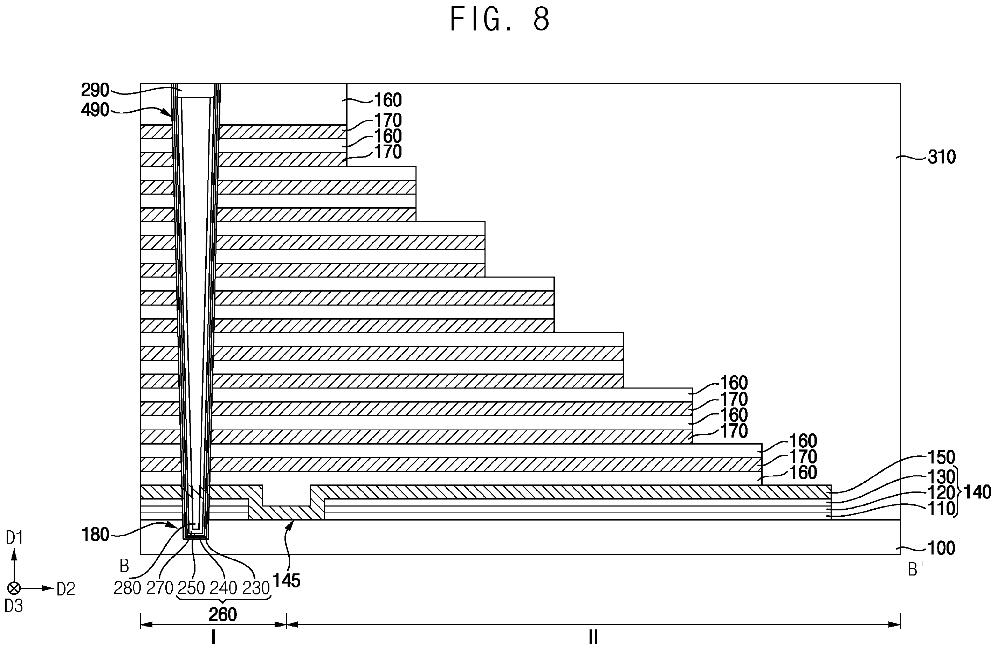

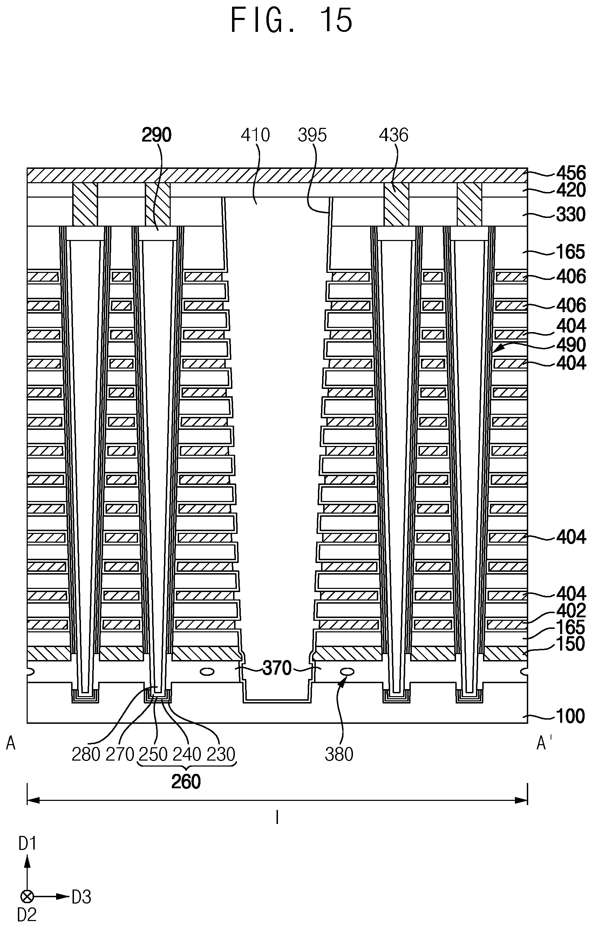

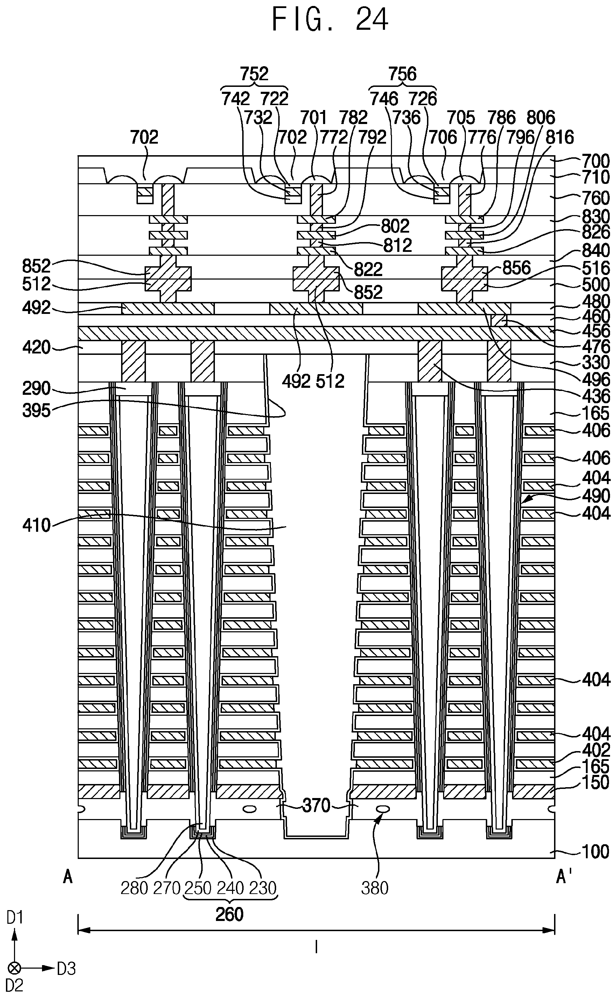

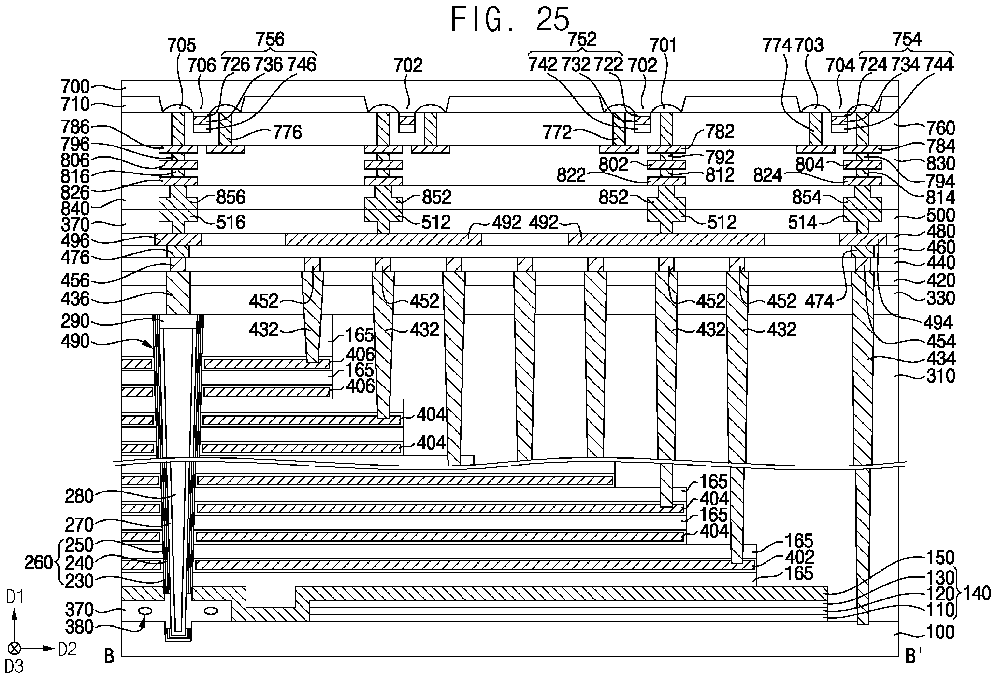

FIGS. 1 to 28 are plan views and cross-sectional views illustrating a method of manufacturing a semiconductor device, for example, a vertical channel NAND flash memory device in accordance with example embodiments.

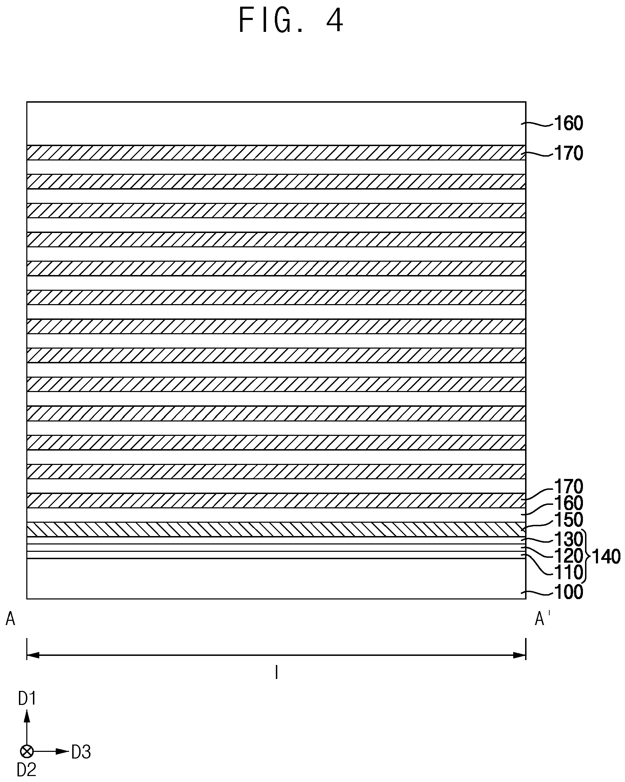

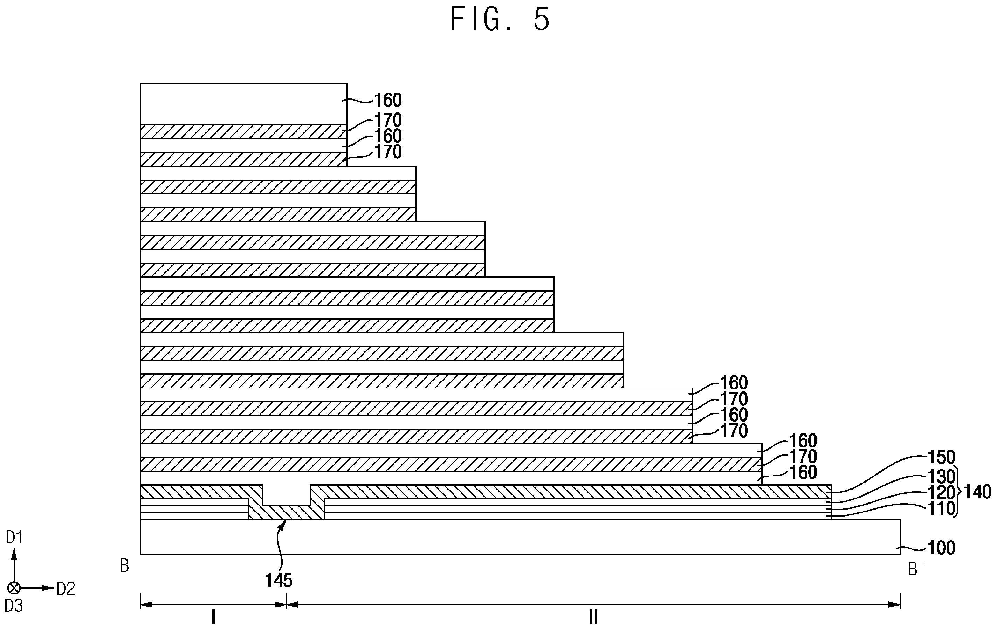

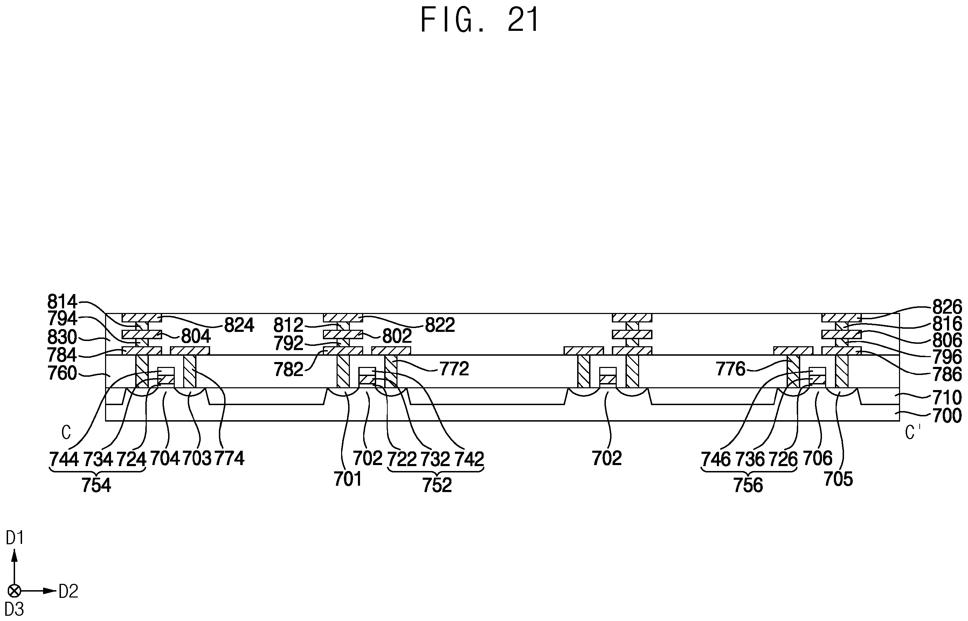

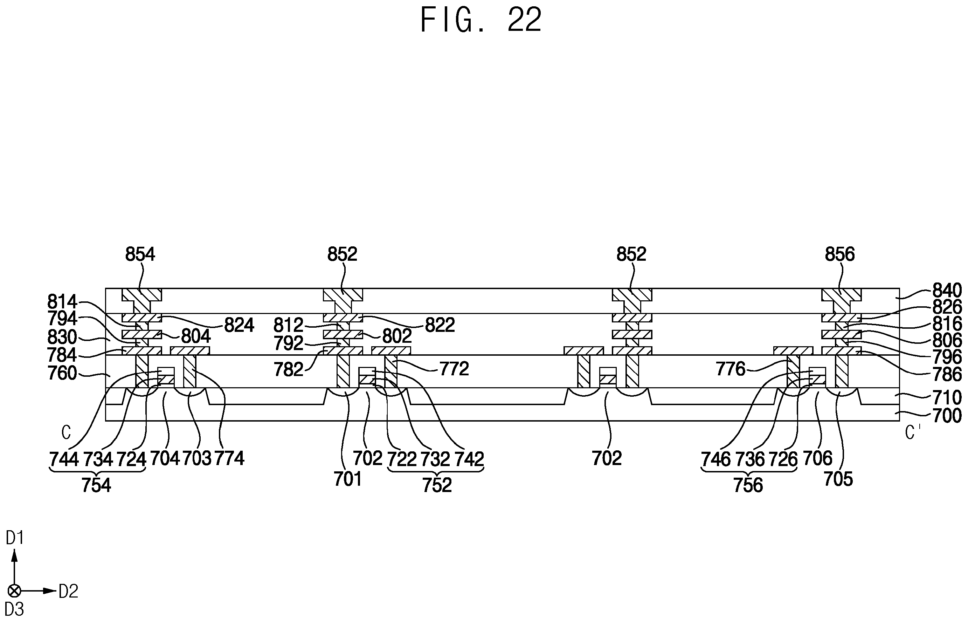

Particularly, FIGS. 1-3, 6, 9, 14, 19-20, 23 and 26-28 are the plan views, FIGS. 4, 7, 10-13, 15, 17 and 24 are cross-sectional views taken along lines A-A' of corresponding plan views, respectively, and FIGS. 5, 8, 16, 18 and 25 are cross-sectional views taken along lines B-B' of corresponding plan views, respectively, and FIGS. 21 and 22 are cross-sectional views taken along lines C-C' of corresponding plan views, respectively.

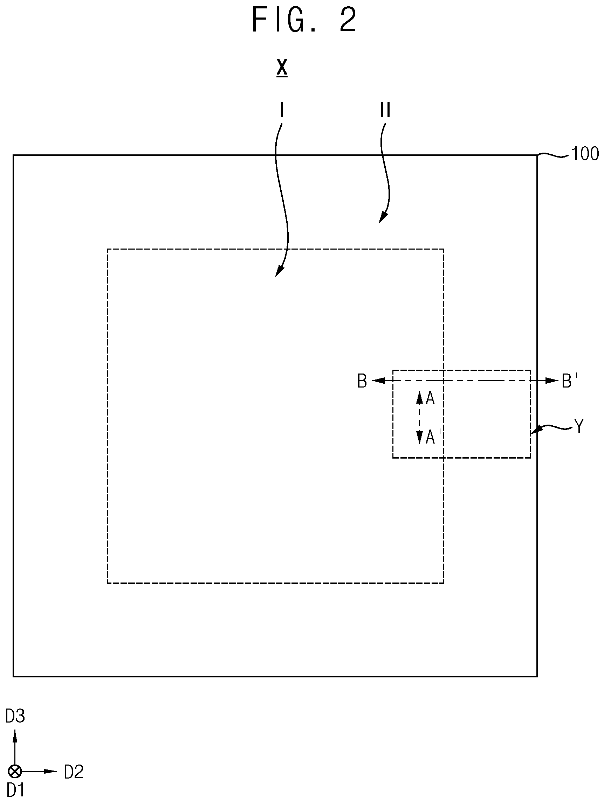

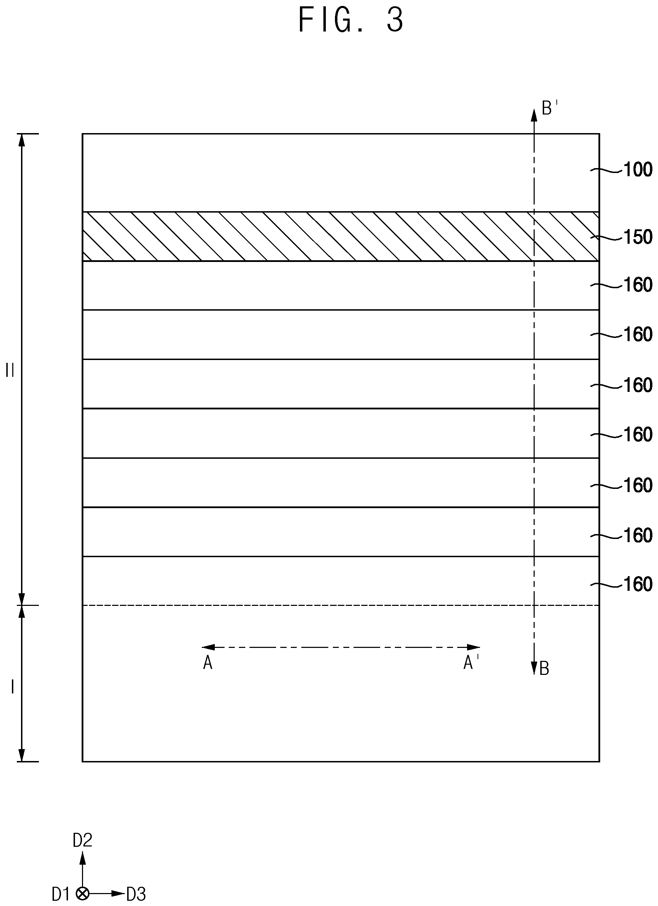

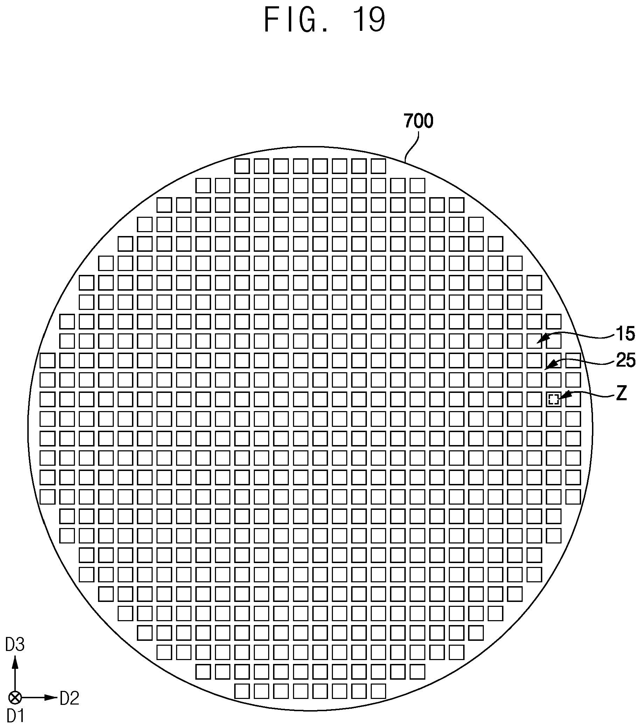

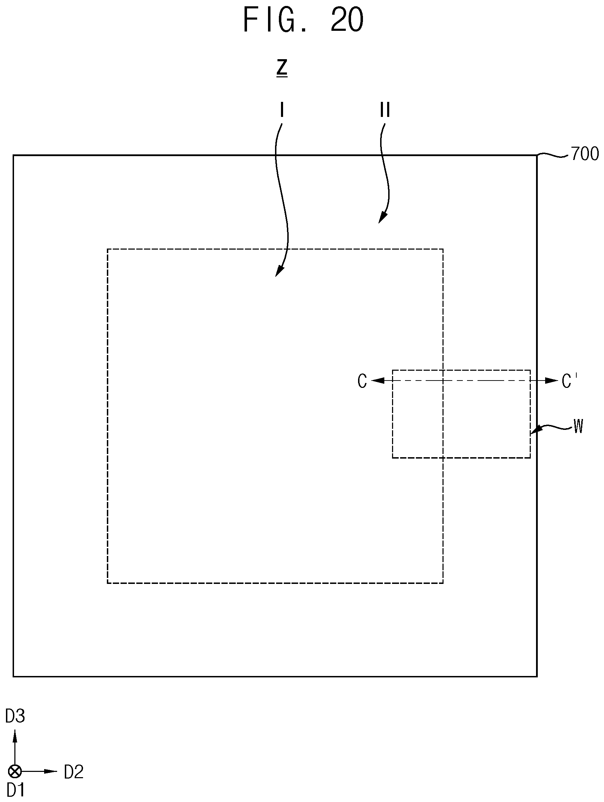

FIG. 2 is an enlarged plan view of region X of FIG. 1, and FIG. 20 is an enlarged plan view of region Z of FIG. 19. FIGS. 3 to 18 are drawings of region Y of FIG. 2, and FIGS. 21 and 22 are drawings of region W of FIG. 20.

Referring to FIG. 1, a first substrate 100 including a first chip region 10 and a first scribe lane region 20 is prepared.

In example embodiments, the first substrate 100 may be a wafer including a semiconductor material, e.g., silicon, germanium, silicon-germanium, etc., and may have a circular shape in a plan view.

In example embodiments, n-type impurities, e.g., phosphorus, arsenic, etc., may be doped in the first substrate 100, and thus the first substrate 100 may serve as a common source plate (CSP). Alternatively, a metal silicide layer including, e.g., tungsten silicide may be formed on the first substrate 100, and the first substrate 100 may serve as the CSR

In example embodiments, a plurality of first chip regions 10 may be spaced apart from each other in the second and third directions D2 and D3 on the first substrate 100. In an example embodiment, the first chip regions 10 may be arranged in a lattice pattern in a plan view, and the first scribe lane region 20 may be formed between the first chip regions 10. The first scribe lane region surrounds the first chip regions 10. Thus, the first scribe lane region 20 may include extension portions extending in the second and third directions D2 and D3, respectively, and crossing each other.

Referring to FIG. 2, the first chip region 10 may include first and second regions I and II.

In example embodiments, the first region I may be a cell array region in which memory cells are formed, and the second region II may be a pad region or an extension region in which pads electrically connected to contact plugs for applying electric signals to the memory cells are formed. The second region II may at least partially surround the first region I.

Referring to FIGS. 3 to 5, a sacrificial layer structure 140 and a support layer 150 may be formed on the first substrate 100, the sacrificial layer structure 140 may be partially removed to form a first opening 145 exposing an upper surface of the first substrate 100, and a support layer 150 may be formed on an upper surface of the sacrificial layer structure 140 and the exposed upper surface of the first substrate 100.

The sacrificial layer structure 140 may include first, second and third sacrificial layers 110, 120 and 130 sequentially stacked in the first direction DI. Each of the first and third sacrificial layers 110 and 130 may include an oxide, e.g., silicon oxide, and the second sacrificial layer 120 may include a nitride, e.g., silicon nitride.

The first opening 145 may have various layouts in a plan view. For example, a plurality of first openings 145 may be spaced apart from each other in the second and third directions D2 and D3 on the first region I of the first substrate 100, the first opening 145 may extend in the second direction D2 or in the third direction D3 on an interface between the first and second regions I and II of the first substrate 100, and a plurality of first openings 145, each of which may extend in the second direction D2, may be spaced apart from each other in the third direction D3 on the second region II of the first substrate 100. FIG. 5 shows the first opening 145 extending in the third direction D3 on the interface between the first and second regions I and II of the first substrate 100.

The support layer 150 may include a material having an etching selectivity with respect to the first to third sacrificial layers 110, 120 and 130, e.g., polysilicon doped with n-type impurities. The support layer 150 may have a constant thickness, and thus a portion of the support layer 150 may form a first recess in the first opening 145. The portion of the support layer 150 in the first opening 145 may also be referred to as a support pattern.

An insulation layer 160 and a fourth sacrificial layer 170 may be alternately and repeatedly stacked on the support layer 150 in the first direction DI, and a mold layer including the insulation layers 160 and the fourth sacrificial layers 170 may be formed. The insulation layer 160 may include an oxide, e.g., silicon oxide, and the fourth sacrificial layer 170 may include a material having an etching selectivity with respect to the insulation layer 160, e.g., a nitride such as silicon nitride.

FIG. 5 shows that the first insulation layers 160 and the fourth sacrificial layers 170 are stacked at fourteen levels and thirteen levels, respectively, however, example embodiments are not limited thereto.

A photoresist layer may be formed on an uppermost one of the first insulation layers 160, may be patterned to form a photoresist pattern, and the uppermost one of the insulation layers 160 and an uppermost one of the fourth sacrificial layers 170 may be etched using the photoresist pattern as an etching mask. Thus, a portion of one of the insulation layers 160 directly under the uppermost one of the fourth sacrificial layers 170 may be exposed. After performing a trimming process for reducing an area of the photoresist pattern, the uppermost one of the insulation layers 160, the uppermost one of the fourth sacrificial layers 170, the exposed one of the insulation layers 160 and one of the fourth sacrificial layer 170 directly under the exposed one of the insulation layers 160 may be etched by an etching process using the reduced photoresist pattern as an etching mask.

The trimming process and the etching process may be repeatedly performed to form a mold having a staircase shape and including a plurality of step layers each of which may include one fourth sacrificial layer 170 and one insulation layer 160 sequentially stacked. Hereinafter, the "step layer' may refer to all portions of the fourth sacrificial layer 170 and the insulation layer 160 at the same level, which may include an unexposed portion as well as an exposed portion of the fourth sacrificial layer 170 and the insulation layer 160, and a "step" may refer to only the exposed portion of the "step layer.' In example embodiments, the steps may be arranged in the second direction D2. Alternatively, the steps may be arranged in the third direction D3. In some example embodiments, the steps may also be arranged in both the second direction D2 and the third direction D3.

An edge portion of the support layer 150 may be not covered by the mold, but may be exposed.

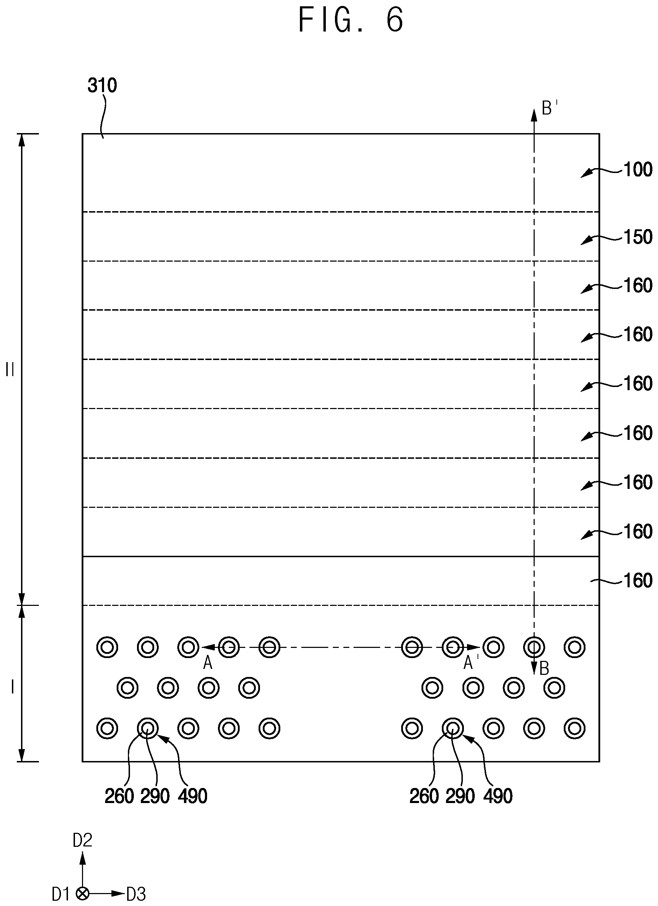

Referring to FIGS. 6 to 8, a first insulating interlayer 310 may be formed on the first substrate 100 to cover the mold, the support layer 150 and the sacrificial layer structure 140, and may be planarized until an upper surface of the uppermost one of the insulation layers 160 is exposed. Thus, a sidewall of the mold, an upper surface and a sidewall of the support layer 150 and a sidewall of the sacrificial layer structure 140 may be covered by the first insulating interlayer 310.

A channel hole 180 may be formed through the mold, the support layer 150 and the sacrificial layer structure 140 to expose the upper surface of the first substrate 100. In some example embodiments, the channel hole 180 may extend into the first substrate 100. A charge storage structure layer and a channel layer may be sequentially formed on a sidewall of the channel hole 180, the exposed upper surface of the first substrate 100, an upper surface of the uppermost one of the first insulation layers 160 of the mold and the first, and an upper surface of the first insulating interlayer 310, and a filling layer may be formed on the channel layer to fill the channel hole 180.

The channel layer may include, e.g., polysilicon, and the filling layer may include an oxide, e.g., silicon oxide. The charge storage structure layer may include a first blocking layer, a charge storage layer and a tunnel insulation layer sequentially stacked on an inner wall of the channel hole 180. The first blocking layer and the tunnel insulation layer may include an oxide, e.g., silicon oxide, and the charge storage layer may include a nitride, e.g., silicon nitride.

The filling layer, the channel layer and the charge storage structure layer may be planarized until the upper surface of the uppermost one of the insulation layers 160 is exposed. Thus, a filling pattern 280, a channel 270 and charge storage structure 260 may be formed in the channel hole 180. The charge storage structure 260 may include a first blocking pattern 230, a charge storage pattern 240 and a tunnel insulation pattern 250 sequentially stacked.

In example embodiments, the filling pattern 280 may have a shape of a pillar extending in the first direction DI, the channel 270 may have a shape of a cup covering a sidewall and a lower surface of the filling pattern 280, and the charge storage structure 260 may have a shape of a cup covering an outer sidewall and a lower surface of the channel 270.

Upper portions of the channel 270 and the filling pattern 280 may be removed to form a first trench, and a capping pattern 290 may be formed to fill the first trench. In example embodiments, the capping pattern 290 may include polysilicon doped with impurities or amorphous silicon doped with impurities, and if the capping pattern 290 includes amorphous silicon doped with impurities, a crystallization process may be further performed on the capping pattern 290.

The charge storage structure 260, the channel 270, the filling pattern 280 and the capping pattern 290 in the channel hole 180 may form a memory channel structure 490. In example embodiments, a plurality of memory channel structures 490 may be spaced apart from each other in the second and third directions D2 and D3 on the first region I of the first substrate 100. Each of the memory channel structures 490 may have a width gradually decreasing from a top toward a bottom thereof (i.e., toward the first substrate 100).

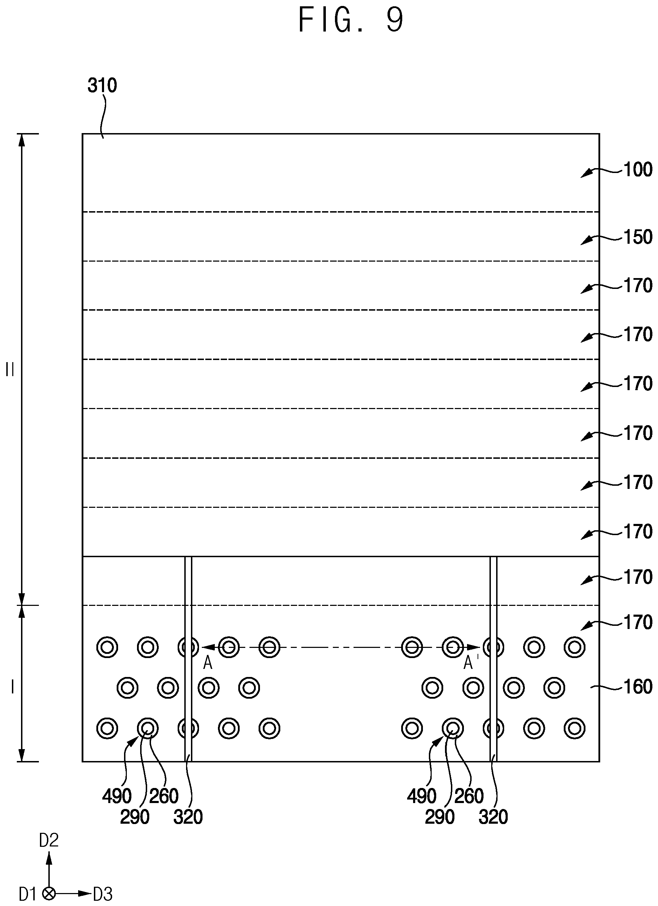

Referring to FIG. 9, the first insulating interlayer 310, ones of the insulation layers 160 and ones of the fourth sacrificial layers 170 may be etched to form a second opening extending in the second direction D2 through the first insulating interlayer 310, the ones of the insulation layers 160 and the ones of the fourth sacrificial layers 170, and a first division pattern 320 may be formed in the second opening.

In example embodiments, the first division pattern 320 may extend in the second direction D2 on the first and second regions I and II of the first substrate 100, and may extend through, e.g., two upper step layers of the mold. Thus, the fourth sacrificial layers 170 at the upper two levels, respectively, of the mold may be divided in the third direction D3 by the first division pattern 320. In an example embodiment, the first division pattern 320 may extend through some of the memory channel structures 490.

The first division pattern 320 may include an oxide, e.g., silicon oxide, or an insulating nitride, e.g., silicon nitride.

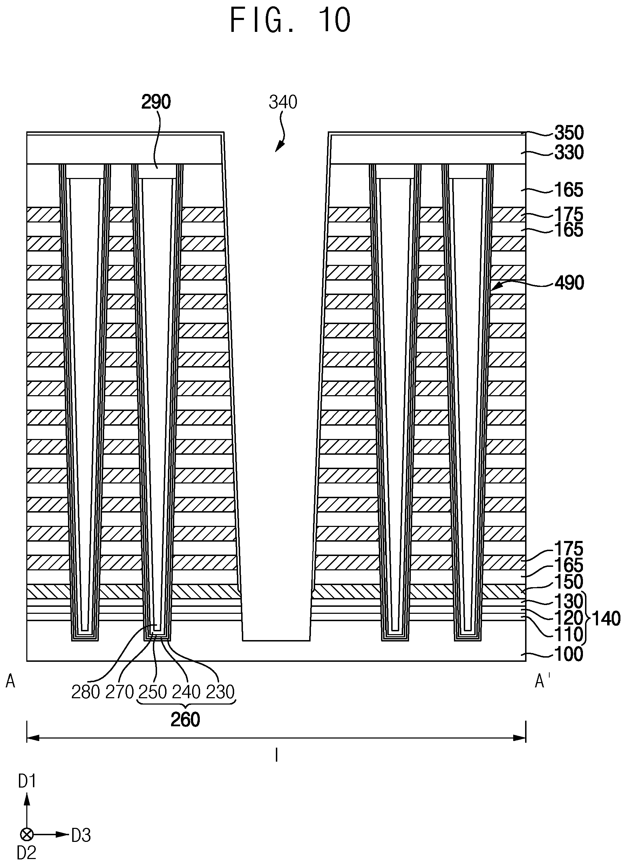

Referring to FIG. 10, a second insulating interlayer 330 may be formed on the first insulating interlayer 310 and the first division pattern 320, and a third opening 340 may be formed through the first and second insulating interlayers 310 and 330 and the mold on the first substrate 100 by, e.g., a dry etching process.

The dry etching process may be performed until an upper surface of the support layer 150 or the support pattern is exposed through the third opening 340, and further the third opening 340 may extend through an upper portion of the support layer 150 or the support pattern. In example embodiments, the third opening 340 may extend in the second direction D2 on the first and second regions I and II, and a plurality of third openings 340 may be spaced apart from each other in the third direction D3. As the third opening 340 is formed, the first insulation layer 160 of the mold may be divided into a plurality of first insulation patterns 165 each of which may extend in the second direction D2, and the fourth sacrificial layer 170 may be divided into a plurality of fourth sacrificial patterns 175 each of which may extend in the second direction D2.

A spacer layer may be formed on a sidewall of the third opening 340 and an upper surface of the second insulating interlayer 330, and an anisotropic etching process may be performed to remove a portion of the spacer layer on a bottom of the third opening 340 so that a spacer 350 may be formed. Accordingly, the upper surface of the support layer 150 or the support pattern may be partially exposed.

The exposed portion of the support layer 150 or the support pattern and a portion of the sacrificial layer structure 140 thereunder may be removed so that the third opening 340 may be enlarged downwardly. Thus, the third opening 340 may expose the upper surface of the first substrate 100, and further extend through an upper portion of the first substrate 100.

In example embodiments, the spacer 350 may include, e.g., undoped polysilicon or undoped amorphous silicon. If the spacer 350 includes undoped amorphous silicon, the spacer 350 may be crystallized by heat during formation of other layers so as to include undoped polysilicon.

When the sacrificial layer structure 140 is partially removed, the sidewall of the third opening 340 may be covered by the spacer 350, and thus the first insulation pattern 165 and the fourth sacrificial pattern 175 of the mold may not be removed with the sacrificial layer structure 140.

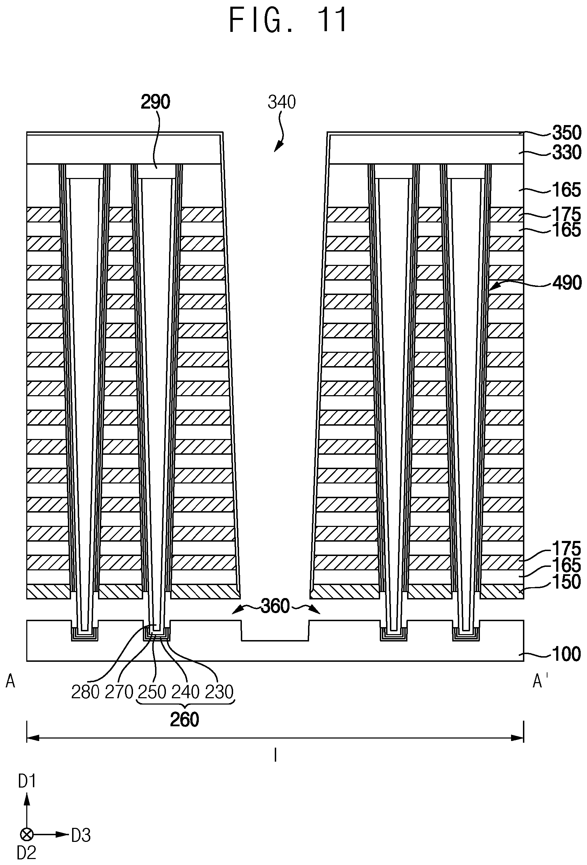

Referring to FIG. 11, the sacrificial layer structure 140 may be removed by, e.g., a wet etching process through the third opening 340, and thus a first gap 360 may be formed.

In example embodiments, the wet etching process may be performed using an etching solution, e.g., HF and/or H3P04.

As the first gap 360 is formed, a lower surface of the support layer 150 and the upper surface of the first substrate 100 adjacent to the third opening 340 may be exposed. Additionally, a sidewall of the charge storage structure 260 may be exposed by the first gap 360, and a lateral portion of the charge storage structure 260 exposed by the first gap 360 may also be removed to expose an outer sidewall of the channel 270. Thus, the charge storage structure 260 may be divided into an upper portion covering most portion of the outer sidewall of the channel 270 and a lower portion covering a lower surface of the channel 270 on the first substrate 100.

When the first gap 360 is formed by the wet etching process, the support layer 150 and the support pattern may not be removed, and thus the mold may not collapse.

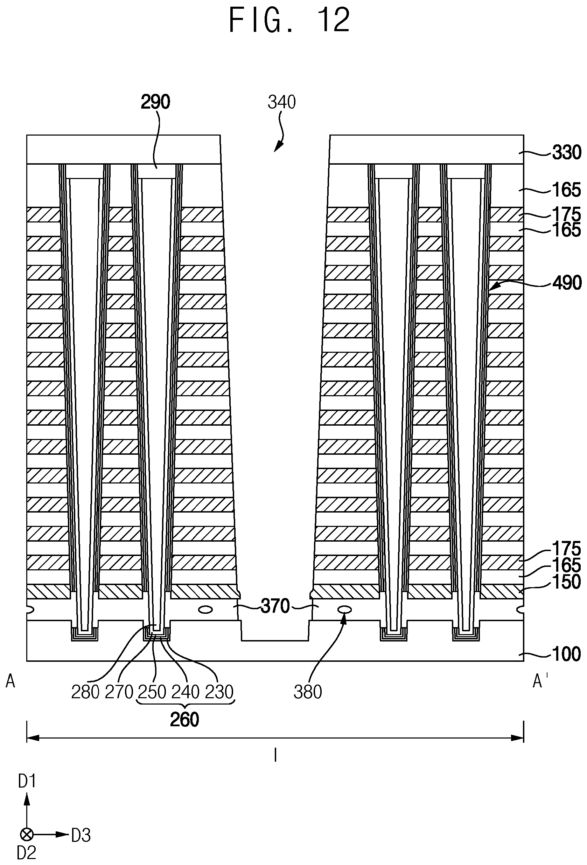

Referring to FIG. 12, the spacer 350 may be removed, a channel connection layer may be formed on the sidewall of the third opening 340 and in the first gap 360, and a portion of the channel connection layer in the third opening 340 may be removed by, e.g., an etch back process to form a channel connection pattern 370 in the first gap 360.

As the channel connection pattern 370 is formed, the channels 270 between the third openings 340 neighboring in the third direction D3 on the first region I of the first substrate 100 may be connected with each other.

The channel connection pattern 370 may include, e.g., amorphous silicon doped with n-type impurities, and may be crystallized during formation of other layers to include polysilicon doped with n-type impurities.

An air gap 380 may be formed in the channel connection pattern 370.

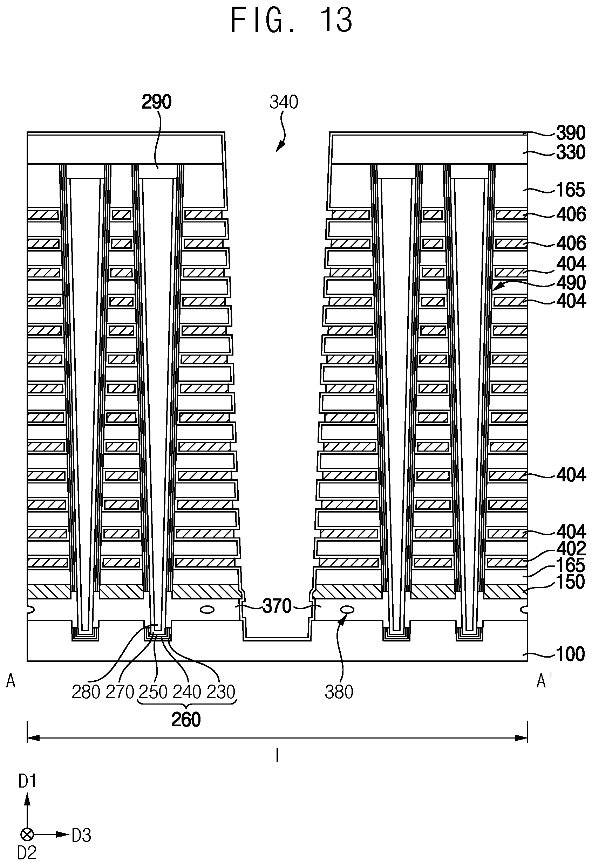

Referring to FIG. 13, the fourth sacrificial patterns 175 exposed by the third opening 340 may be removed to form a second gap between neighboring ones of the first insulation patterns 165 in the first direction DI, and a portion of an outer sidewall of the first blocking pattern 230 may be exposed by the second gap.

In example embodiments, a wet etching process may be performed using, e.g., phosphoric acid (H3P04) or sulfuric acid (H2S04) to remove the fourth sacrificial patterns 175.

A second blocking layer 390 may be formed on the outer sidewall of the first blocking pattern 230 exposed by the third opening 340, inner walls of the second gaps, surfaces of the first insulation patterns 165, a sidewall and a lower surface of the support layer 150, a sidewall of the support pattern, a sidewall of the channel connection pattern 370, the upper surface of the first substrate 100 and the upper surface of the second insulating interlayer 330, and a gate electrode layer may be formed on the second blocking layer 390.

In example embodiments, the second blocking layer 390 may include a metal oxide, e.g., aluminum oxide, hafnium oxide, zirconium oxide, etc. The gate electrode layer may include a gate conductive layer and a gate barrier layer covering lower and upper surfaces and a sidewall of the gate conductive layer. The gate conductive layer may include a metal having a low resistance, e.g., tungsten, titanium, tantalum, etc., and the gate barrier layer may include a metal nitride, e.g., titanium nitride, tantalum nitride, etc.

The gate electrode layer may be partially removed to form a gate electrode in each of the second gaps. In example embodiments, the gate electrode layer may be partially removed by a wet etching process.

In example embodiments, the gate electrode may extend in the second direction D2, and a plurality of gate electrodes may be spaced apart from each other in the first direction DI to form a gate electrode structure. The gate electrode structure may have a staircase shape in which lengths in the second direction D2 of the gate electrodes decrease from a lowermost level toward an uppermost level. An end portion of each of the gate electrodes in the second direction D2 that is not overlapped by ones of the gate electrodes overlying each of the gate electrodes may be referred to as a pad. In example embodiments, a plurality of gate electrode structures may be spaced apart from each other in the third direction D3 by the third opening 340.

The gate electrode structure may include first, second and third gate electrodes 402, 404 and 406 sequentially stacked in the first direction DI. Additionally, a fourth gate electrode (not shown) serving as a gate induced drain leakage (GiDL) gate electrode for operating body erase using GIDL phenomenon under the first gate electrode 402 and/or over the third gate electrode 406.

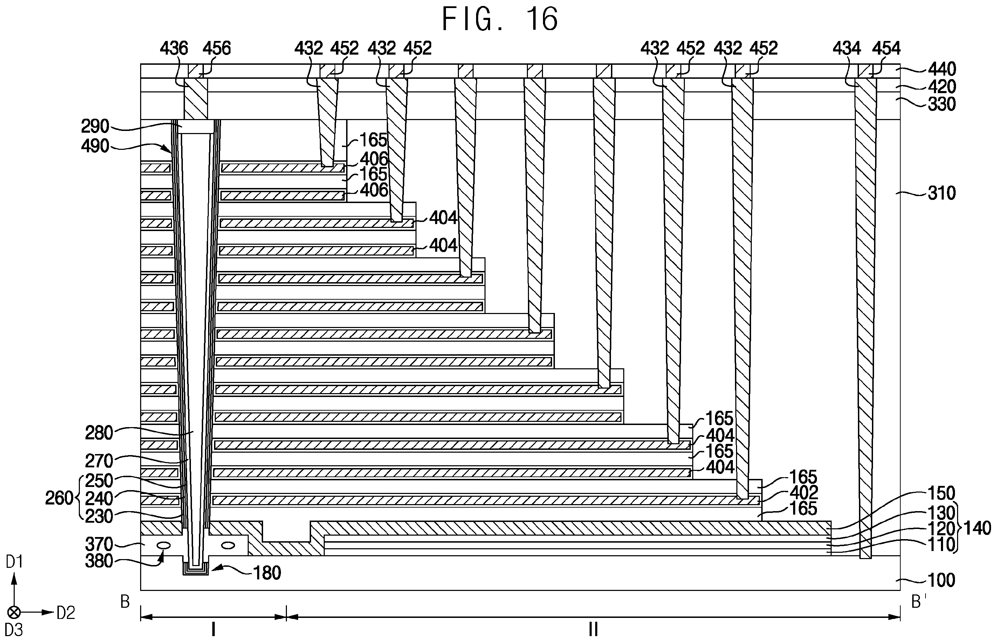

In example embodiments, the first gate electrode 402 may serve as a ground selection line (GSL), and the third gate electrode 406 may serve as a string selection line (SSL). FIG. 16 shows that the first gate electrode 402 is formed at a lowermost level, and the third gate electrodes 404 are formed at upper two levels, respectively, however, example embodiments are not limited thereto. The second gate electrodes 404 may be formed at a plurality of levels, respectively, between the first and third gate electrodes 402 and 406, and may serve as word lines, respectively.

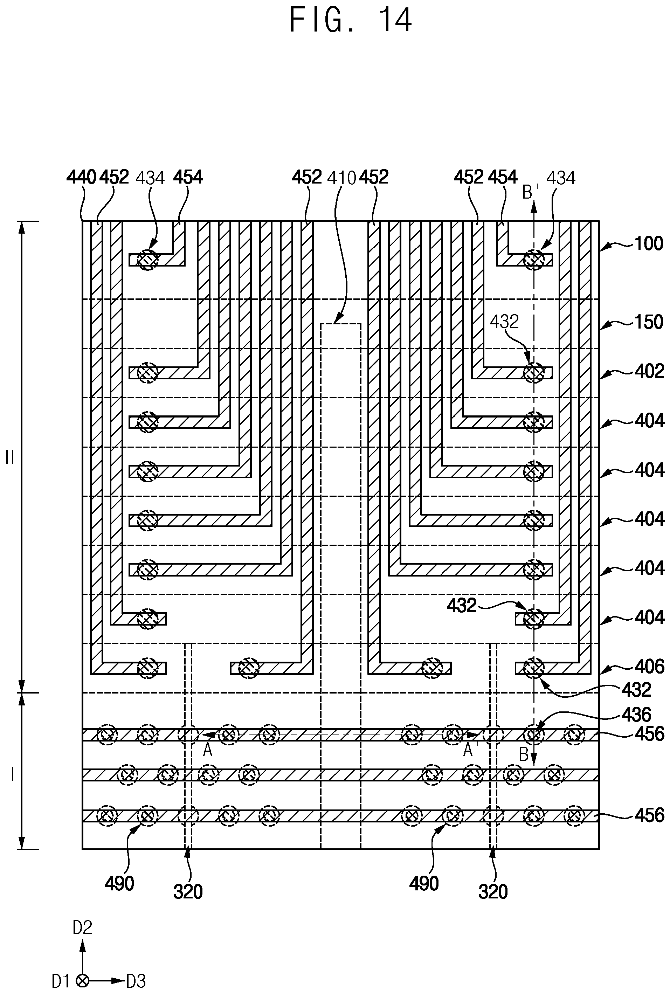

Referring to FIGS. 14 to 16, a division layer may be formed on the second blocking layer 390 to fill the third opening 340, and may be planarized until the upper surface of the second insulating interlayer 330 is exposed to form a second division pattern 410. During the planarization process a portion of the second blocking layer 390 on the upper surface of the second insulating interlayer 330 may be removed, and a remaining portion of the second blocking layer 390 may form a second blocking pattern 395

The second division pattern 410 may extend in the second direction D2 on the first and second regions I and II of the first substrate 100, and a plurality of second division patterns 410 may be spaced apart from each other in the third direction D3. The second division pattern 410 may include an oxide, e.g., silicon oxide.

A third insulating interlayer 420 including an oxide, e.g., silicon oxide may be formed on the second insulating interlayer 330, the second division pattern 410 and the second blocking pattern 395, and first contact plugs 432 extending through the first to third insulating interlayers 310, 330 and 420, the first insulation pattern 165 and the second blocking pattern 395 to contact corresponding ones of the first to third gate electrodes 402, 404 and 406, respectively, a second contact plug 434 extending through the first to third insulating interlayers 310, 330 and 420 to contact the upper surface of the first substrate 100, and third contact plugs 436 extending through the second and third insulating interlayers 330 and 420 to contact a corresponding one of the capping patterns 290, respectively, may be formed. In example embodiments, each of the first to third contact plugs 432, 434 and 436 may have a width gradually decreasing from a top toward a bottom thereof (i.e., toward the first substrate 100).

A fourth insulating interlayer 440 including an oxide, e.g., silicon oxide may be formed on the third insulating interlayer 420, and first to third wirings 452, 454 and 456 may be formed through the fourth insulating interlayer 440 to contact upper surfaces of the first to third contact plugs 432, 434 and 436, respectively. The first to third contact plugs 432, 434 and 436 and the first to third wirings 452, 454 and 456 may have various layouts.

The first to third contact plugs 432, 434 and 436 and the first to third wirings 452, 454 and 456 may include, e.g., a metal, a metal nitride, a metal silicide, doped polysilicon, etc.

In example embodiments, the third wiring 456 may extend in the third direction D3 on the first region I of the first substrate 100, and a plurality of third wirings 456 may be spaced apart from each other in the second direction D2. Each of the third wirings 456 may serve as a bit line of the semiconductor device.

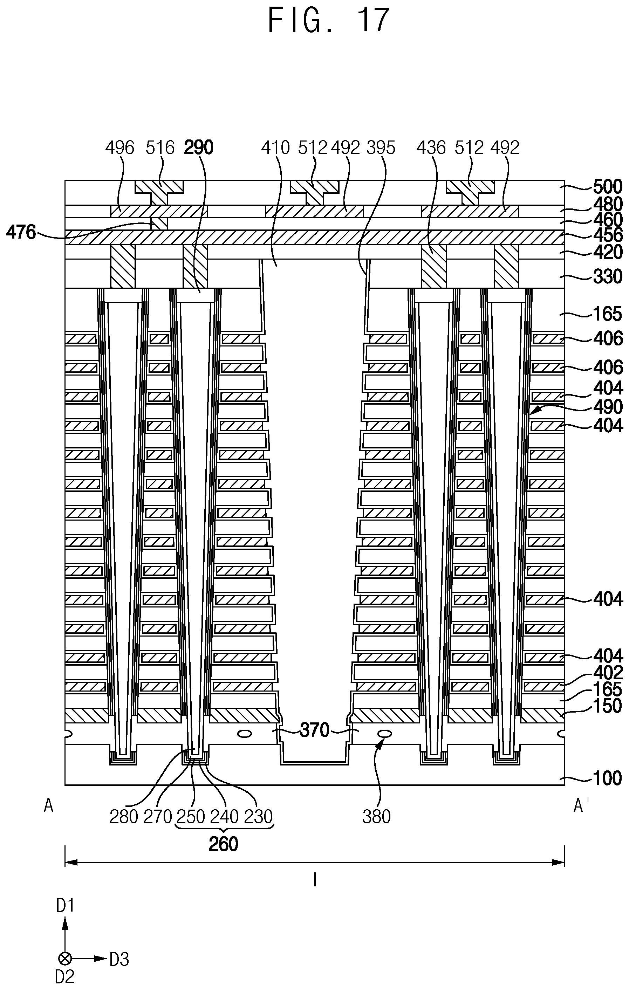

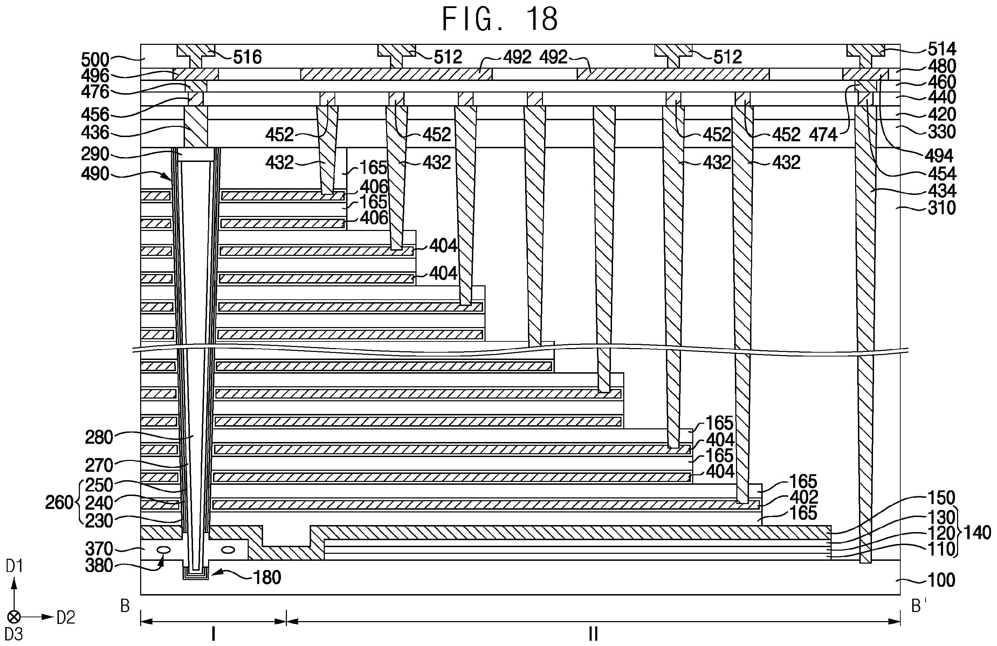

Referring to FIGS. 17 and 18, a fifth insulating interlayer 460 including an oxide, e.g., silicon oxide may be formed on the fourth insulating interlayer 440, and a first via extending through the fifth insulating interlayer 460 to contact the first wiring 452, and second and third vias 474 and 476 extending through the fifth insulating interlayer 460 to contact the second and third wirings 454 and 456, respectively, may be formed.

A sixth insulating interlayer 480 may be formed on the fifth insulating interlayer 460, the first via and the second and third vias 474 and 476, and a fourth wiring extending through the sixth insulating interlayer 480 to contact the first via, fifth and sixth wirings 494 and 496 extending through the sixth insulating interlayer 480 to contact the second and third vias 474 and 476, respectively, and a first conductive pattern 492 may be formed. The sixth insulating interlayer 480 may include an insulating material, e.g., silicon oxide or silicon nitride.

The first via, the second and third vias 474 and 476, the fourth wiring, the fifth and sixth wirings 494 and 496, and the first conductive pattern 492 may include a conductive material, e.g., a metal, a metal nitride, a metal silicide, doped polysilicon, etc.

In example embodiments, a plurality of first conductive patterns 492 may be spaced apart from each other in the second and third directions D2 and D3 on the first and second regions I and II of the first substrate 100, and may have various layouts. For example, a plurality of first conductive patterns 492 each of which may extend in the second direction D2 may be spaced apart from each other in the third direction D3. Alternatively, a plurality of first conductive patterns 492 each of which may extend in the third direction D3 may be spaced apart from each other in the second direction D2.

In example embodiments, the first conductive patterns 492 neighboring in a horizontal direction substantially parallel to the upper surface of the first substrate 100, and a portion of the sixth insulating interlayer 480 between the neighboring first conductive patterns 492 may form a capacitor. Alternatively, each of the first conductive patterns 492 may form a resistor having a resistance greater than resistances of the fourth wiring and the fifth and sixth wirings 494 and 496. Alternatively, each of the first conductive patterns 492 may form an inductor.

A seventh insulating interlayer 500 including an oxide, e.g., silicon oxide may be formed on the sixth insulating interlayer 480, the fourth wiring and the fifth and sixth wirings 494 and 496, and a first bonding pattern extending through the seventh insulating interlayer 500 to contact the fourth wiring, a second bonding pattern 512 extending through the seventh insulating interlayer 500 to contact the first conductive pattern 492, and third and fourth bonding patterns 514 and 516 extending through the seventh insulating interlayer 500 to contact the fifth and sixth wirings 494 and 496, respectively, may be formed.

In example embodiments, the first bonding patterns, the second bonding patterns 512, the third boding patterns 514 and the fourth bonding patterns 516 may be spaced apart from each other in the second and third directions D2 and D3 on the first and second regions I and II of the first substrate 100, and may be arranged in a lattice pattern in a plan view. In an example embodiment, each of the first bonding pattern and the second to fourth bonding patterns 512, 514 and 516 may be formed by a dual damascene process, and thus may have a lower portion and an upper portion having a width greater than a width of the lower portion. Alternatively, each of the first bonding pattern and the second to fourth bonding patterns 512, 514 and 516 may be formed by a single damascene process.

The first bonding pattern and the second to fourth bonding patterns 512, 514 and 516 may include a metal having a low resistance, e.g., copper, aluminum, etc.

Referring to FIG. 19, a second substrate 700 including a second chip region 15 and a second scribe lane region 25 is prepared.

The second substrate 700 may be a wafer substantially similar to the first substrate 100. Thus, the second substrate 700 may include a semiconductor material, e.g., silicon, germanium, silicon-germanium, etc., and may have a circular shape in a plan view. The second chip region 15 and the second scribe lane region 25 may have layouts substantially similar to the layouts of the first chip region 10 and the first scribe lane region 20 of the first substrate 100.

Referring to FIG. 20, the second chip region 15 of the second substrate 700 may include first and second regions I and II, which may be a cell array region and a pad region, respectively, correspondingly to the first chip region 10 of the first substrate 100.

Referring to FIG. 21, upper circuit patterns may be formed on the second substrate 700 including first to third active regions 702, 704 and 706 that may be defined by a first isolation pattern 710. The upper circuit patterns may include, e.g., transistors, upper contact plugs, upper wirings, upper vias, etc.

FIG. 21 shows first to third transistors including first to third upper gate electrodes 752, 754 and 756, respectively, on the second substrate 700 and first to third impurity regions 701, 703 and 706, respectively, however, example embodiments are not limited thereto. The first to third transistors may have various layouts.

The first upper gate electrode 752 may include a first upper gate insulation pattern 722, a first upper gate electrode 732 and a first upper gate mask 742 sequentially stacked on the first active region 702, the second upper gate electrode 754 may include a second upper gate insulation pattern 724, a second upper gate electrode 734 and a second upper gate mask 744 sequentially stacked on the second active region 704, and the third upper gate electrode 756 may include a third upper gate insulation pattern 726, a third upper gate electrode 736 and a third upper gate mask 746 sequentially stacked on the third active region 706.

A first upper insulating interlayer 760 including an oxide, e.g., silicon oxide may be formed on the second substrate 700, and may cover the first to third transistors. First to third upper contact plugs 772, 774 and 776 may extend through the first upper insulating interlayer 760 to contact the first to third impurity regions 701, 703 and 706, respectively.

A first upper wiring 782 may be formed on the first upper insulating interlayer 760, and may contact an upper surface of the first upper contact plug 772. A first upper via 792, a fourth upper wiring 802, a fourth upper via 812 and a seventh upper wiring 822 may be sequentially stacked on the first upper wiring 782. Additionally, a second upper wiring 784 may be formed on the first upper insulating interlayer 760, and may contact an upper surface of the second upper contact plug 774. A second upper via 794, a fifth upper wiring 804, a fifth upper via 814 and an eighth upper wiring 824 may be sequentially stacked on the second upper wiring 784. Further, a third upper wiring 786 may be formed on the first upper insulating interlayer 760, and may contact an upper surface of the third upper contact plug 776. A third upper via 796, a sixth upper wiring 806, a sixth upper via 816 and a ninth upper wiring 826 may be sequentially stacked on the third upper wiring 786.

The first to ninth upper wirings 782, 784, 786, 802, 804, 806, 822, 824 and 826 and the first to sixth upper vias 792, 794, 796, 812, 814 and 816 may be formed on the first upper insulating interlayer 760, and may be covered by a second upper insulating interlayer 830 including an oxide, e.g. silicon oxide.

The first to third upper contact plugs 772, 774 and 776, the first to sixth upper vias 792, 794, 796, 812, 814 and 816, and the first to ninth upper wirings 782, 784, 786, 802, 804, 806, 822, 824 and 826 may include a metal, e.g., tungsten, titanium, tantalum, etc., and may also include a metal nitride.

Referring to FIG. 22, a third upper insulating interlayer 840 including an oxide, e.g., silicon oxide may be formed on the second upper insulating interlayer 830 and the seventh to ninth upper wirings 822, 824 and 826, and sixth to eighth bonding patterns 852, 854 and 856 may be formed through the third insulating interlayer 840 to contact the seventh to ninth upper wirings 822, 824 and 826.

In example embodiments, the sixth to eighth bonding patterns 852, 854 and 856 may be formed at positions corresponding to positions of the second to fourth bonding patterns 512, 514 and 516, respectively, on the first substrate 100. A fifth bonding pattern may be further formed on the second substrate 700 at a position corresponding to a position of the first bonding pattern on the first substrate 100, and a fourth transistor and upper contact plugs, upper wirings and upper vias may be further formed under the fifth bonding pattern.

The fifth bonding pattern and the sixth to eighth bonding patterns 852, 854 and 856 may be formed by a dual damascene process or a single damascene process, and may include a metal having a low resistance, e.g., copper, aluminum, etc.

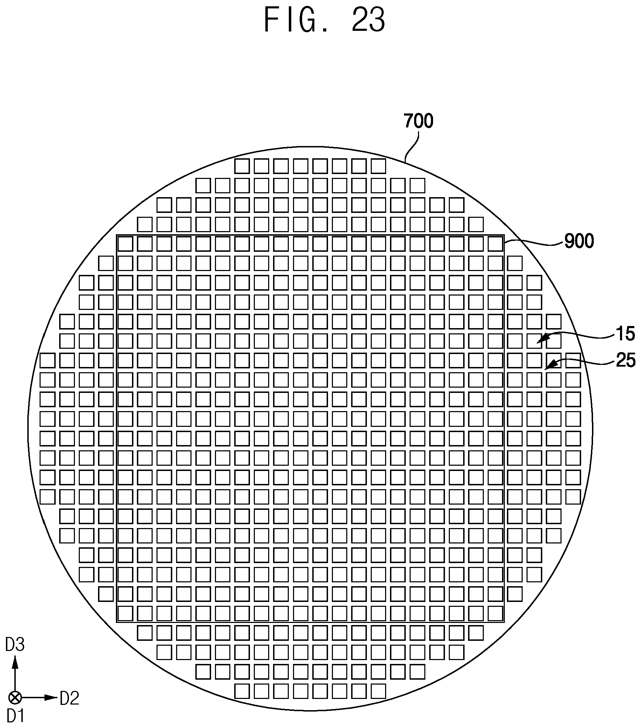

Referring to FIGS. 23 to 25, a first dicing process or a first sawing process is performed to separate (i.e., cut off) a first portion 900 of the second substrate 700, and is turned over and bonded with a corresponding portion of the first substrate 100.

The third upper insulating interlayer 840 on the second substrate 700 may be bonded with the seven insulating interlayer 500 on the first substrate 100, and the fifth bonding pattern and the sixth to eighth bonding patterns 852, 854 and 856 on the second substrate 700 may contact the first bonding pattern and the second to fourth bonding patterns 512, 514 and 516, respectively on the first substrate 100.

Thus, upper and lower portions of structures on the second substrate 700 may be changed into lower and upper portions, respectively, of the structures.

In accordance with the claimed invention, the first portion 900 of the second substrate 700 that is separated by the first dicing process is a central portion of the second substrate 700, and includes a plurality of second chip regions 15. That is, the first dicing process is performed along a portion of the second scribe lane region 25 surrounding ones of the second chip regions 15 on the central portion of the second substrate 700.

In an example embodiment, the first portion 900 of the second substrate 700 may have a square or rectangular shape in a plan view.

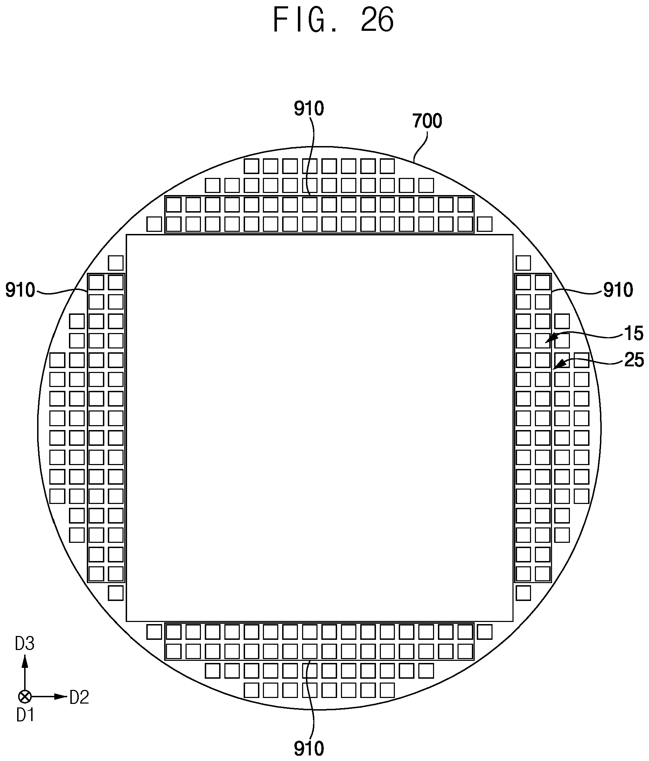

Referring to FIG. 26, in accordance with the claimed invention, a second dicing process is performed to separate a second portion 910 of the second substrate 700, and may be turned over and is bonded with a corresponding portion of the first substrate 100.

As illustrated with reference to FIGS. 23 to 25, the fifth bonding pattern and the sixth to eighth bonding patterns 852, 854 and 856 on the second substrate 700 may contact the first bonding pattern and the second to fourth bonding patterns 512, 514 and 516, respectively on the first substrate 100.

In example embodiments, the second portion 910 of the second substrate 700 that may be separated by the second dicing process may be a first edge portion of the second substrate 700 adjacent to the central portion of the second substrate 700, and includes a plurality of second chip regions 15. That is, the second dicing process is performed along a portion of the second scribe lane region 25 surrounding ones of the second chip regions 15 on the first edge portion of the second substrate 700.

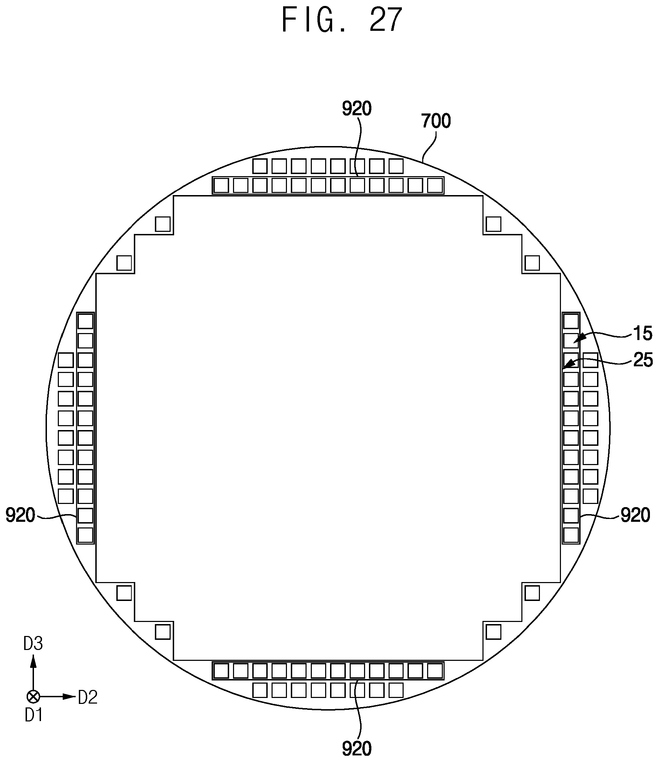

Referring to FIG. 27, processes substantially the same as or similar to those illustrated with reference to FIG. 26 may be performed.

Thus, a third dicing process is performed to separate a third portion 920 of the second substrate 700, and may be turned over and is bonded with a corresponding portion of the first substrate 100.

In example embodiments, the third portion 920 of the second substrate 700 that may be separated by the third dicing process may be a second edge portion of the second substrate 700 adjacent to the first edge portion of the second substrate 700, and includes a plurality of second chip regions 15. That is, the third dicing process may be performed along a portion of the second scribe lane region 25 surrounding ones of the second chip regions 15 on the second edge portion of the second substrate 700.

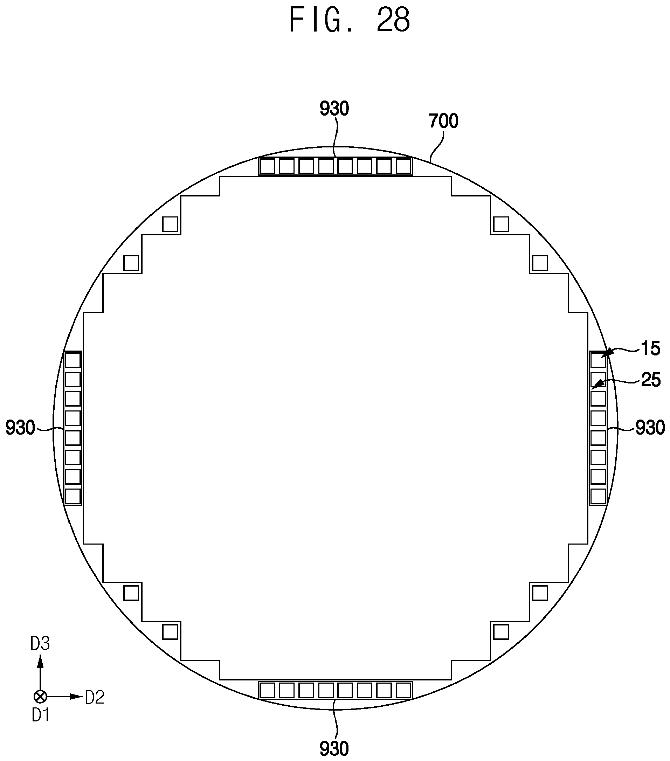

Referring to FIG. 28, processes substantially the same as or similar to those illustrated with reference to FIG. 26 may be performed.

Thus, a fourth dicing process may be performed to separate a fourth portion 930 of the second substrate 700, and may be turned over and bonded with a corresponding portion of the first substrate 100.

In example embodiments, the fourth portion 930 of the second substrate 700 that may be separated by the fourth dicing process may be a third edge portion of the second substrate 700 adjacent to the second edge portion of the second substrate 700, and may include a plurality of second chip regions 15. That is, the fourth dicing process may be performed along a portion of the second scribe lane region 25 surrounding ones of the second chip regions 15 on the third edge portion of the second substrate 700.

If some of the second chip regions 15 that is not separated by a dicing process from the second substrate 700 remain, processes substantially the same as or similar to those illustrated with reference to FIG. 28 may be further performed. However, example embodiments are not limited thereto, and even if ones of the second chip regions 15 remain in the second substrate 700, structures in the remaining ones of the second chip regions 15, which may not satisfy a give criteria, may not be separated from the second substrate 700 to be bonded with the first substrate 100.

A final dicing process is performed on a stacked structure of the first and second substrate 100 and 700, so that a chip including the first substrate 100 having one first chip region 10 and the second substrate 700 having one second chip region 15 is provided.

Warpage may occur on each of the first and second substrates 100 and 700 due to structures thereon, and the warpage may mainly occur on edge portions of the first and second substrates 100 and 700. If the first and second substrates 100 and 700 are entirely stacked, misalignment may occur due to warpage differences between the first and second substrates 100 and 700.

Thus, for example, the fifth bonding pattern and the sixth to eighth bonding patterns 852, 854 and 856 on the second substrate 700 may be not bonded with the first bonding pattern and the second to fourth bonding patterns 512, 514 and 516, respectively, on the first substrate 100, and thus the first and second substrates 100 and 700 may be not securely bonded with each other. Even if the first and second substrates 100 and 700 are securely bonded with each other, electric connections between the structures on the first and second substrates 100 and 700, respectively, may be not reliable due to the misalignment.

However, in accordance with the claimed invention, the second substrate 700 is not entirely bonded with the first substrate 100 by a single process. Rather, the second substrate 700 is divided into a plurality of parts and bonded with corresponding portions, respectively, of the first substrate 100 by a plurality of processes. Thus, the misalignment of the structures on the first and second substrates 100 and 700 due to the warpage differences may be prevented. In this regard, the first and second substrates 100 and 700 are securely bonded with reliable electrical connections between the structures on the first and second substrates 100 and 700.

Process time for bonding the first and second substrates 100 and 700 by a plurality of processes may increase when compared to the bonding the first and second substrates 100 and 700 by a single process. However, the second chip regions 15 are not separated from the second substrate 700 by respective dicing processes, but the second substrate 700 is divided into a plurality of portions including a plurality of second chip regions 15, and the divided portions of the second substrate 700 are separated from the second substrate 700 and bonded with corresponding portions of the first substrate 100. Thus, the increase of the process time may be minimized. Particularly, in accordance with the claimed invention, the central portion of the second substrate 700 of which a warpage occurrence probability is small includes a great number of the second chip regions 15 that are separated from the second substrate 700 by a single dicing process, which may minimize the process time increase.

In the processes illustrated with reference to FIGS. 23 to 28, the second substrate 700 is divided into the first to fourth portions 900, 910, 920 and 930, however, example embodiments are not limited thereto. That is, the second substrate 700 may be divided into more or less than four portions, and a dicing process and a bonding process may be performed by the unit of the divided portions of the second substrate 700. One or ones of the divided portions, e.g., an edge portion of the second substrate 700 may include a single second chip region 15 instead of a plurality of second chip regions 15.

The order of the dicing and bonding processes is not limited to the order described with reference to FIGS. 23 to 28, and for example, the fourth portion 930, the third portion 920, the second portion 910 and the first portion 900 may be separated and bonded with the first substrate 100 in this order, or the first to fourth portions 900, 910, 920 and 930 may be simultaneously separated and bonded with the first substrate 100.

In the processes illustrated with reference to FIGS. 23 to 28, the second substrate 700 is divided and bonded with the first substrate 100, however, example embodiments are not limited thereto, and for example, the first substrate 100 may be diced and bonded with the second substrate 700.

In the processes illustrated with reference to FIGS. 23 to 28, two substrates, that is, the first and second substrates 100 and 700 are stacked to manufacture the chip, however, example embodiments are not limited thereto, and more than two substrates may be stacked to manufacture a chip.

For example, if three substrates are stacked to manufacture the chip, a lower substrate and a middle substrate may be entirely bonded with each other by a single process, and an upper substrate may be divided into a plurality of parts, and separated and bonded with the middle substrate. Finally, the lower, middle and upper substrates may be diced to manufacture the chip.

Alternatively, the middle substrate may be divided into a plurality of parts, and separated and bonded with the lower substrate. Additionally, the upper substrate may be divided into a plurality of parts, and separated and bonded with the middle substrate on the lower substrate. Finally, the lower, middle and upper substrates may be diced to manufacture the chip.

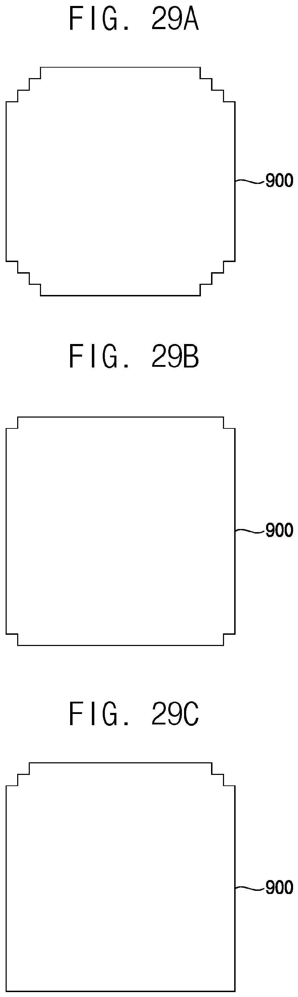

FIGS. 29A, 29B and 29C illustrate plan views illustrating a shape of the first portion 900 of the second substrate 700 separated from the second substrate 700 by the first dicing process.

Referring to FIGS. 29A, 29B and 29C, unlike the shape of the first portion 900 shown in FIG. 23, the first portion 900 may have a square shape or a rectangular shape with corners having a staircase shape in a plan view.

The second substrate 700 has a circular shape in a plan view, and if the first portion 900 of the second substrate 700 is the central portion of the second substrate 700, the first portion 900 may have a square shape or a rectangular shape with staircase shape of corners so as to include more numbers of the second chip regions 15.

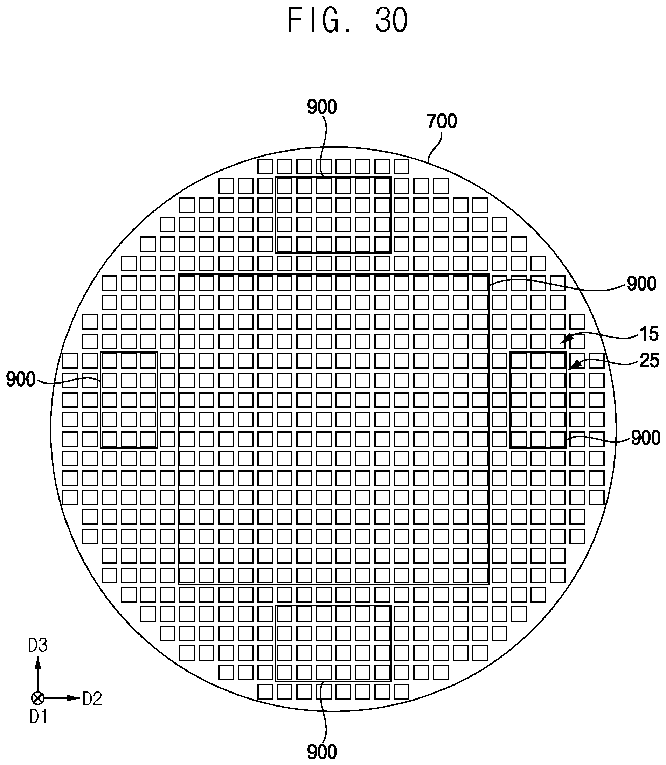

FIGS. 30 to 32 relate to embodiments which do not form part of the claimed invention. Fig. 30 to 32 include plan views illustrating positions and layouts of the first portion 900 of the second substrate 700 separated from the second substrate 700 by the first dicing process.

Referring to FIG. 30, the first portion 900 of the second substrate 700 may include an edge portion as well as the central portion thereof,

That is, the first portion 900 of the second substrate 700 that may be separated by the first dicing process may not necessarily include only ones of the second chip regions 15 in the central portion of the second substrate 700, but may also include ones of the second chip regions 15 in an edge portion thereof. Additionally, the first portion 900 of the second substrate 700 may include ones of the second chip regions 15 in a plurality of edge portions spaced apart from each other.

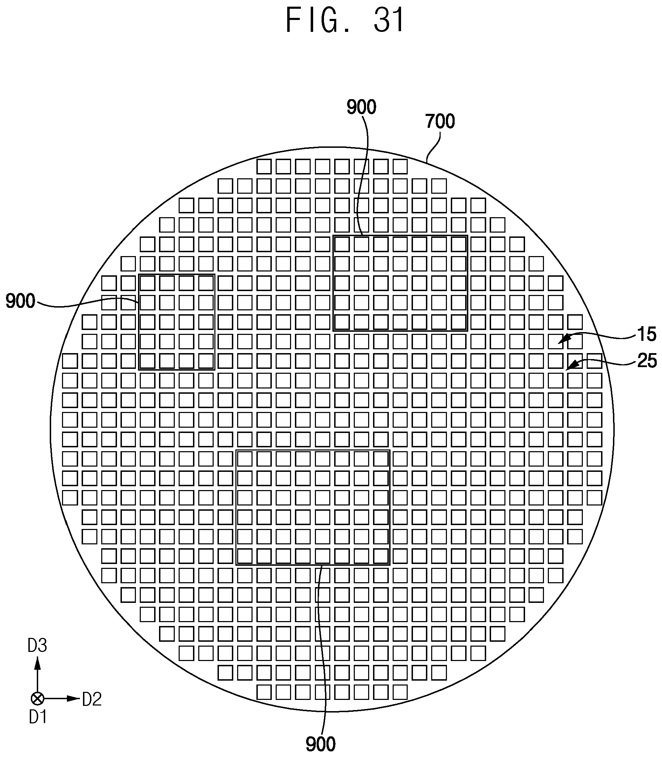

Referring to FIG. 31 the first portion 900 of the second substrate 700 may include ones of the second chip regions 15 in a plurality of central portions of the second substrate 700.

That is, the first portion 900 of the second substrate 700 that may be separated by the first dicing process may not necessarily include ones of the second chip regions 15 in a single central portion of the second substrate 700, but may include ones of the second chip regions 15 in a plurality of central portions thereof. The central portions of the second substrate 700 may have different areas from each other.

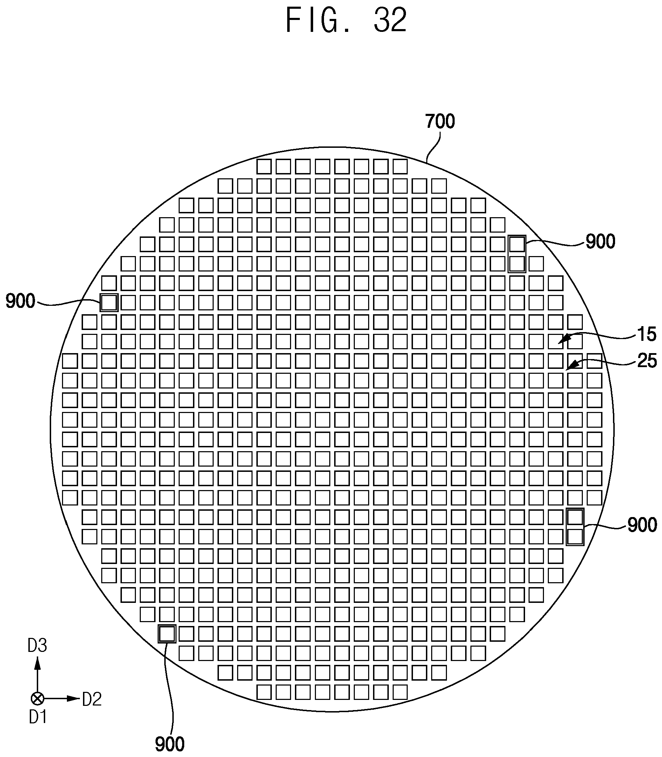

Referring to FIG. 32, the first portion 900 of the second substrate 700 may include ones of the second chip regions 15 in a plurality of edge portions of the second substrate 700.

That is, the first portion 900 of the second substrate 700 that may be separated by the first dicing process may not necessarily include ones of the second chip regions 15 in the central portion of the second substrate 700, but may include ones of the second chip regions 15 in an edge portion thereof. Additionally, the first portion 900 of the second substrate 700 may include ones of the second chip regions 15 in a plurality of edge portions spaced apart from each other.

As illustrated above, the first portion 900 of the second substrate 700 that may be separated by the first dicing process may have various shapes and layouts. Likewise, each of the second to fourth portions 910, 920, 930 and 940 of the second substrate 700 that may be separated by the second to fourth dicing processes, respectively, may also have various shapes and layouts.

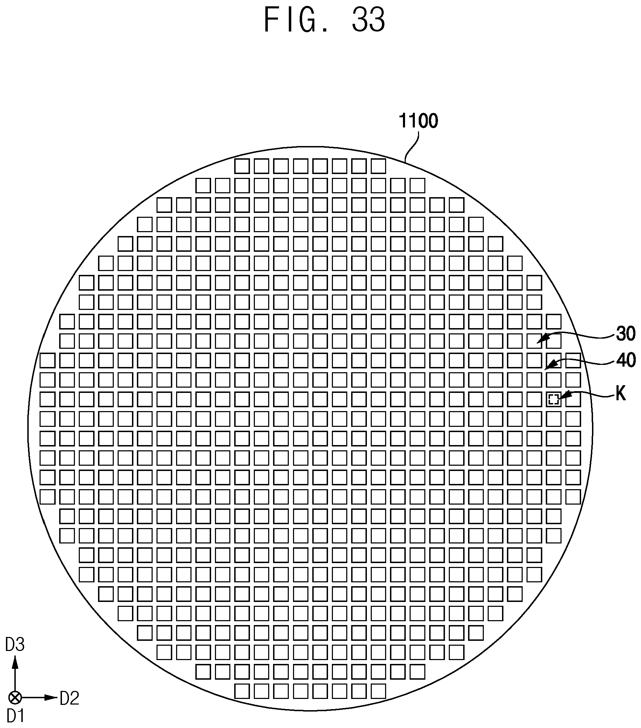

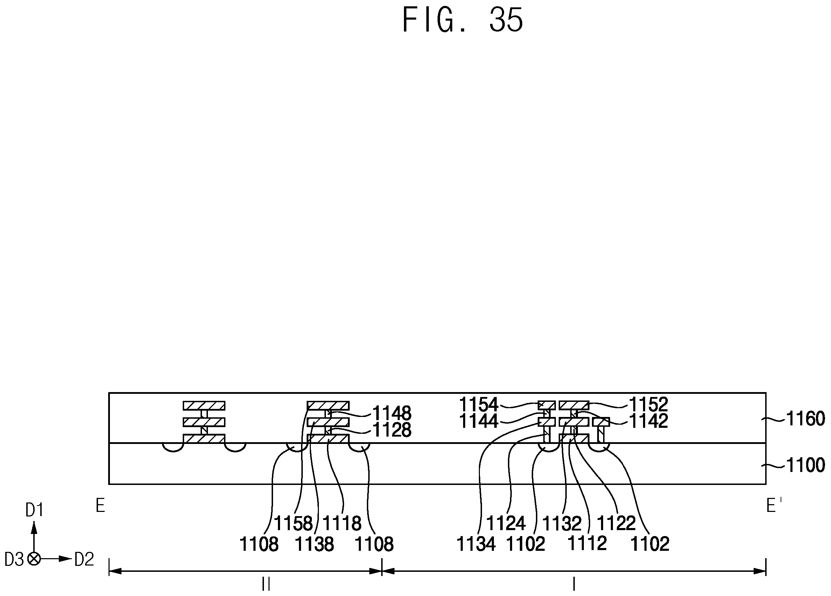

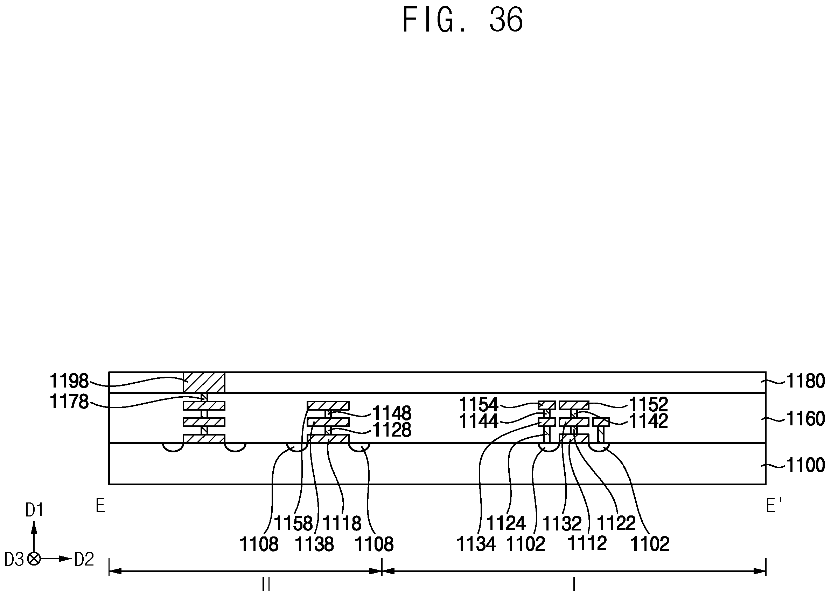

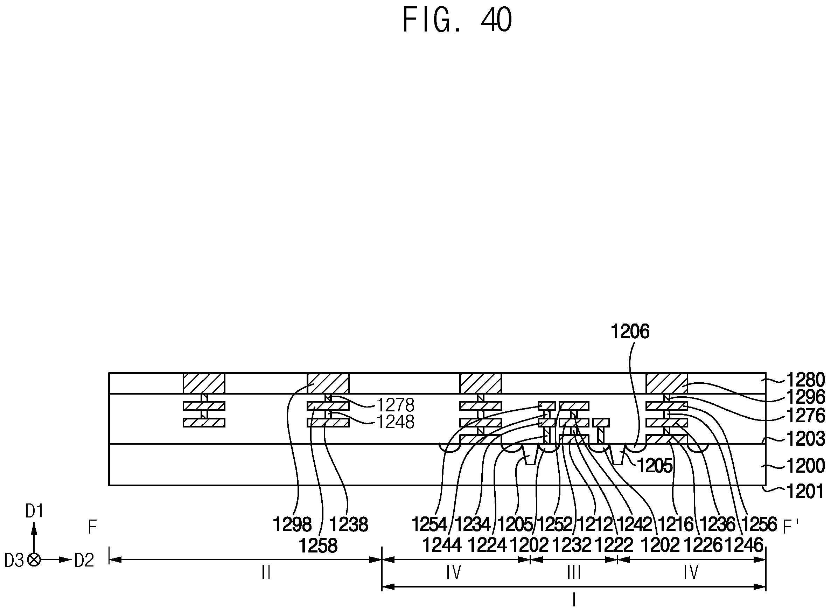

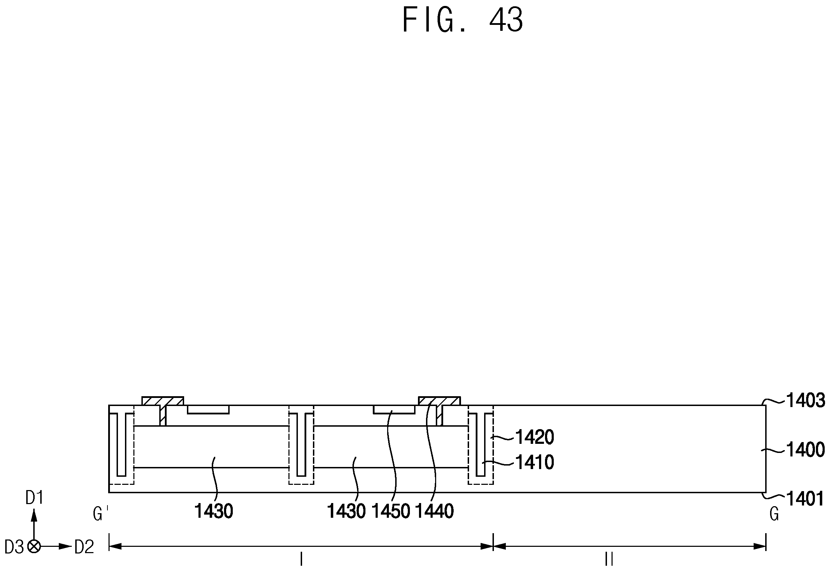

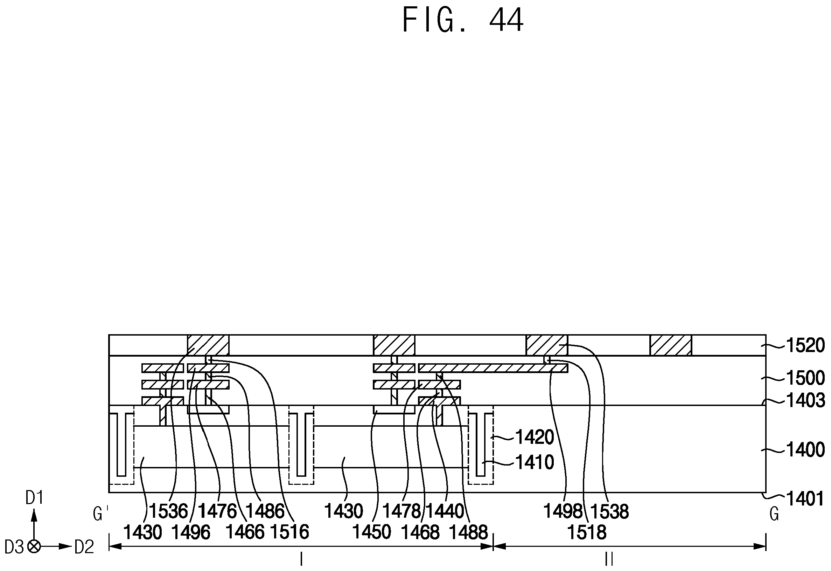

FIGS. 33 to 52 are plan views and cross-sectional views illustrating a method of manufacturing a CMOS image sensor (CIS) in accordance with example embodiments. Particularly, FIGS. 33-34, 37-39 and 41-42 are the plan views, FIGS. 35 and 36 are cross-sectional views taken along lines E-E' of corresponding plan views, respectively, FIGS. 40 and 45-52 are cross-sectional views taken along lines F-F' of corresponding plan views, respectively, and FIGS. 43 and 44 are cross-sectional views taken along line G-G' of corresponding plan views, respectively.

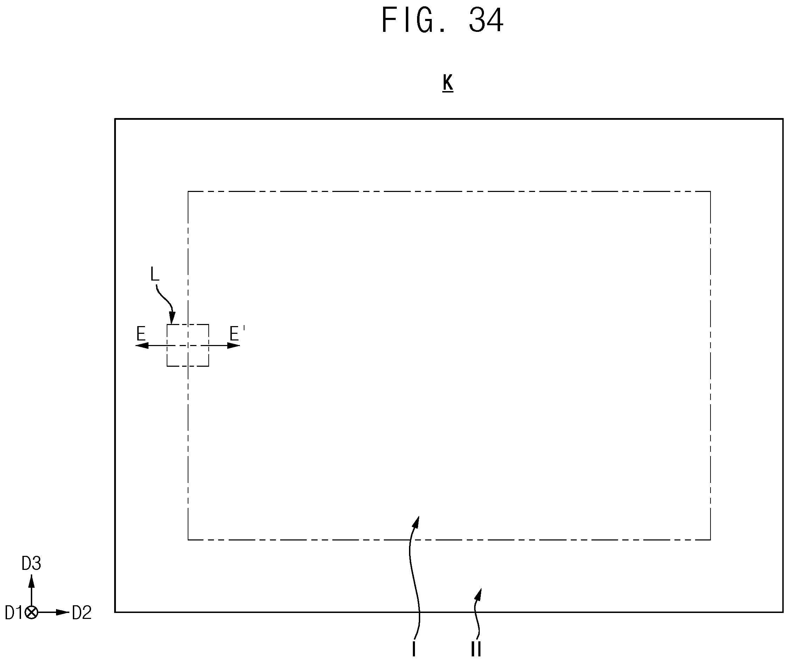

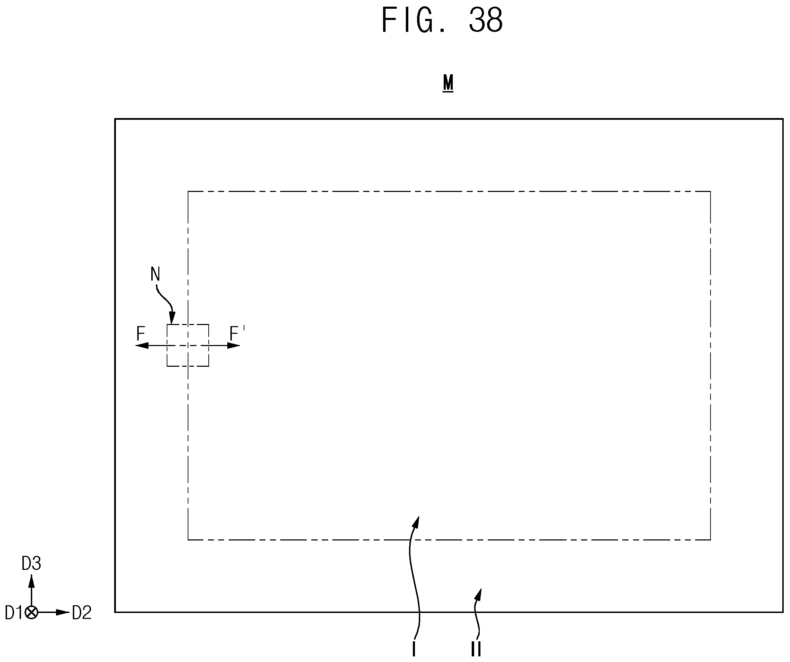

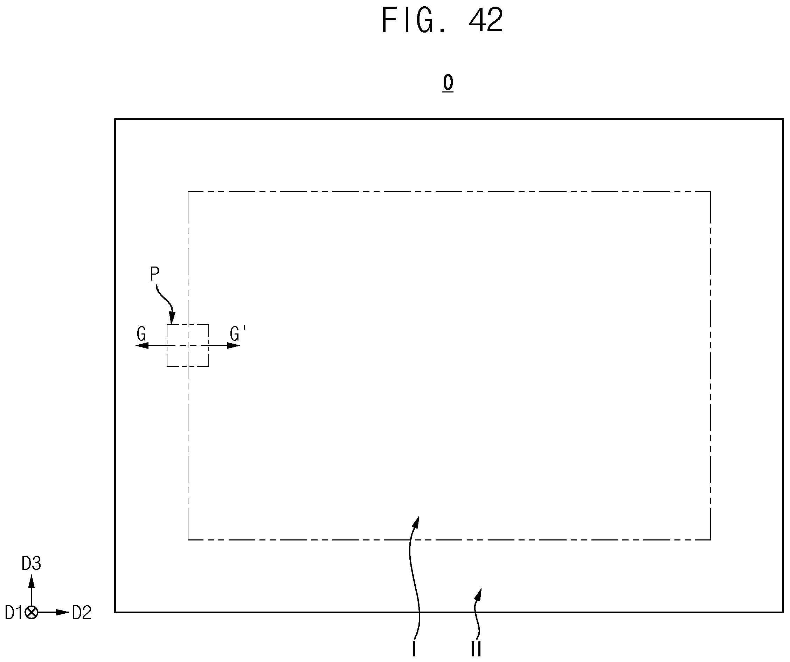

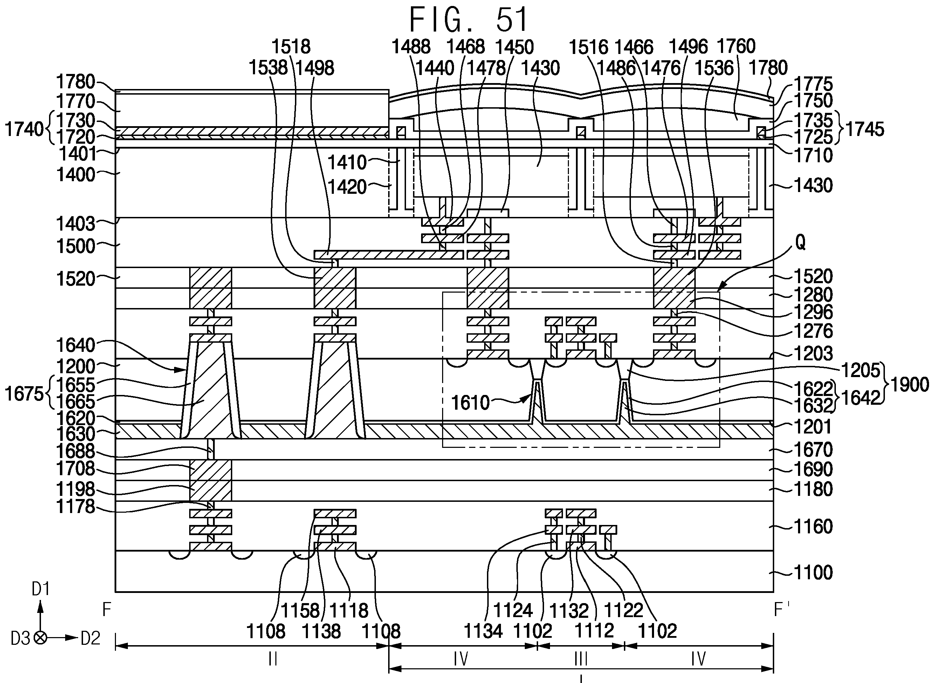

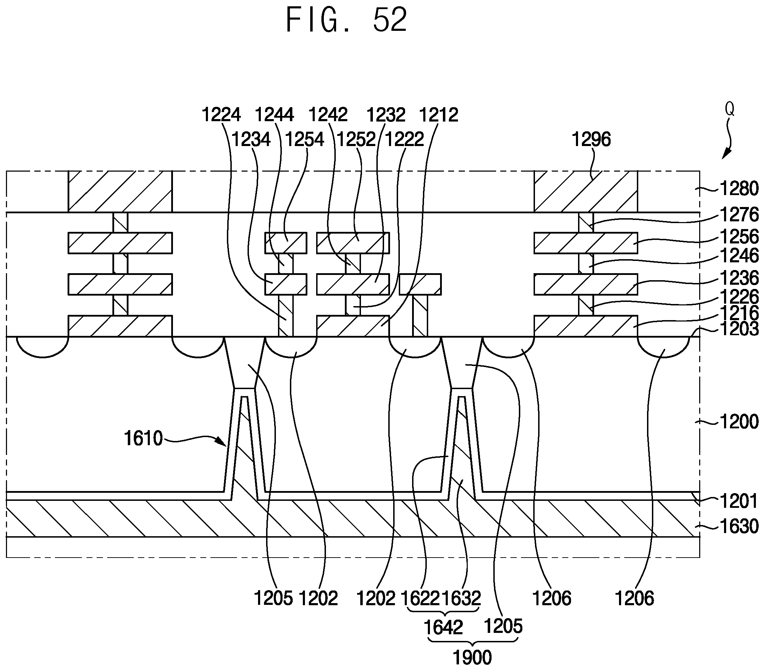

FIGS. 34, 38 and 42 are enlarged plan views of regions K, M and O of FIGS. 33, 37 and 41, respectively, and FIG. 52 is an enlarged plan view of region Q of FIG. 51. Additionally, FIGS. 35 and 36 are drawings of region L of FIG. 34, FIGS. 39 and 40 are drawing of region N of FIG. 38, and FIGS. 43 and 44 are drawings of region P of FIG. 42.

Referring to FIG. 33, a third substrate 1100 including a third chip region 30 and a third scribe lane region 40 may be prepared.

The third substrate 1100 may be a wafer including a semiconductor material, e.g., silicon, germanium, silicon-germanium, etc., and may have a circular shape in a plan view. In example embodiments, a plurality of third chip regions 30 may be spaced apart from each other in the second and third directions D2 and D3 in the third substrate 1100, and the third scribe lane region 40 may be formed between the third chip regions 30 to surround the third chip regions 30.

In example embodiments, the third substrate 1100 may be a substrate on which logic circuit patterns for processing electrical signals, e.g., electronic signals, voltage signals, etc., are formed.

Referring to FIG. 34, the third chip region 30 of the third substrate 1100 may include first and second regions I and II.

In example embodiments, the first region I of the third substrate 1100 may be a pixel region in which pixels are formed, and the second region II of the third substrate 1100 may be a connection region in which connection wirings for transferring electric signals in a vertical direction, that is, in the first direction DI are formed. In example embodiments, the second region II may surround the first region I.

Referring to FIG. 35, fifth and sixth transistors may be formed on the first and second regions I and II of the third substrate 1100.

The fifth transistor may be formed by forming a fifth gate electrode 1112 on the first region I of the third substrate 1100, and doping impurities into upper portions of the third substrate 1100 adjacent to the fifth gate electrode 1112 to form a fourth impurity regions 1102. Additionally, the sixth transistor may be formed by forming a sixth gate electrode 1118 on the second region II of the third substrate 1100, and doping impurities into upper portions of the third substrate 1100 adjacent to the sixth gate electrode 1118 to form a fifth impurity regions 1108.

Contact plugs, wirings and vias may be formed to be electrically connected to the fifth and sixth transistors.

FIG. 35 shows a fourth contact plug 1122, a seventh wiring 1132, a fourth via 1142 and an eighth wiring 1152 sequentially stacked on the fifth gate electrode 11 12 included in the fifth transistor, a fifth contact plug 1124, a ninth wiring 1134, a fifth via 1144 and a tenth wiring 1154 sequentially stacked on the fourth impurity region 1102 included in the fifth transistor, and a sixth contact plug 1128, an eleventh wiring 1138, a sixth via 1148 and a twelfth wiring 1158 sequentially stacked on the sixth gate electrode 11 18 included in the sixth transistor.

An eighth insulating interlayer 1160 may be formed on the third substrate 1100 to cover the fifth and sixth transistors, the fourth to sixth contact plugs 1122, 1124 and 1128, the seventh to twelfth wirings 1132, 1152, 1134, 1154, 1138 and 1158, and the fourth to sixth vias 1142, 1144 and 1148.

Referring to FIG. 36, a seventh via 1178 may be formed through an upper portion of the eighth insulating interlayer 1160 to contact an upper surface of the twelfth wiring 1158, a first adhesion layer 1180 may be formed on the eighth insulating interlayer 1160 and the seventh via 1178, and a ninth bonding pattern 1198 may be formed through the first adhesion layer 1180 to contact the seventh via 1178 on the second region II of the third substrate 1100. The first adhesion layer 1180 may include an insulating nitride, e.g., silicon nitride, and the ninth bonding pattern 1198 may include a metal, e.g., copper.

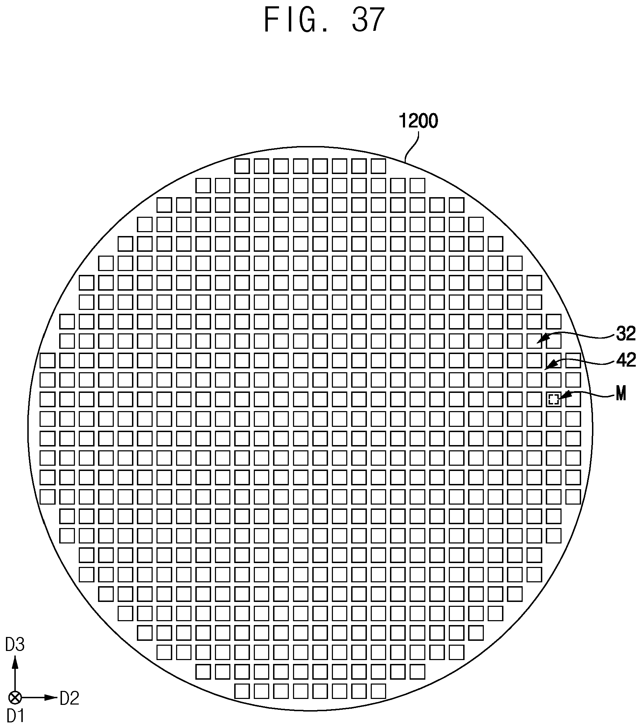

Referring to FIG. 37, a fourth substrate 1200 including a fourth chip region 32 and a fourth scribe lane region 42 may be prepared.

The fourth substrate 1200 may be a wafer substantially similar to the third substrate 1100. Thus, the fourth substrate 1200 may be a wafer including a semiconductor material, e.g., silicon, germanium, silicon-germanium, etc., and may have a circular shape in a plan view. Additionally, the fourth chip region 32 and the fourth scribe lane region 42 included in the fourth substrate 1200 may have layouts substantially similar to the layouts of the third chip region 30 and the third scribe lane region 40, respectively, included in the third substrate 1100.

In example embodiments, the fourth substrate 1200 may be a wafer on which elements for converting electronic signals to voltage signals and memory elements are formed.

Referring to FIG. 38, the fourth chip region 32 of the fourth substrate 1200 may include first and second regions I and II, which may be a pixel region and a connection region, respectively, correspondingly to the third chip region 30 of the third substrate 1100.

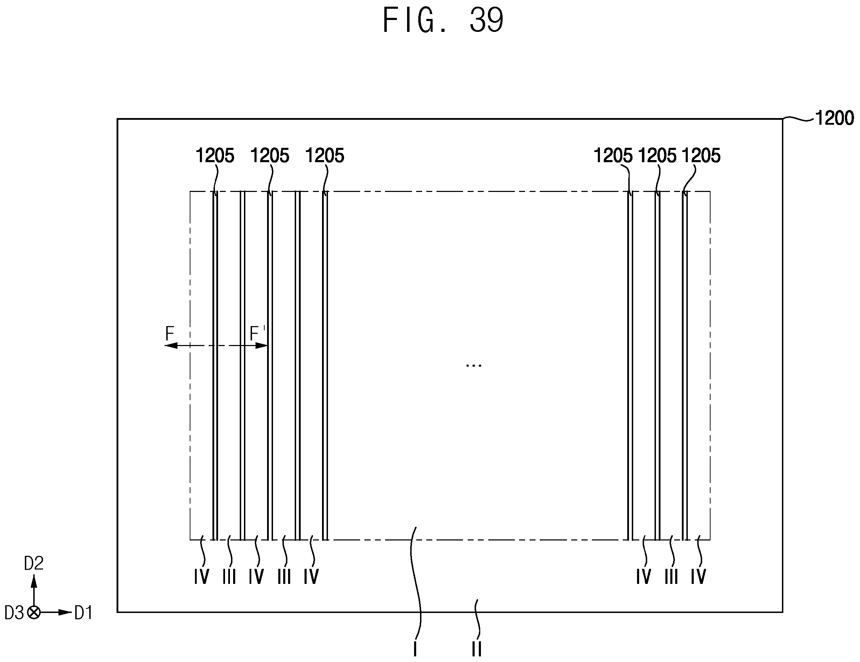

Referring to FIGS. 39 and 40, an upper portion of the fourth substrate 1200 including first and second surfaces 1201 and 1203 opposite to each other in the first direction DI, that is, a portion of the fourth substrate 1200 adjacent to the second surface 1203 may be removed to form a second recess, and a second isolation pattern 1205 may be formed in the second recess.

The second isolation pattern 1205 may extend in the third direction D3 in the first region I of the fourth substrate 1200, and a plurality of second isolation patterns 1205 may be spaced apart from each other in the second direction D2. Thus, the first region I of the fourth substrate 1200 may be divided into third and fourth regions III and IV alternately and repeatedly disposed in the second direction D2.

The third and fourth regions III and IV of the fourth substrate 1200 may be a digital region in which digital block is formed and an analog region in which analog block is formed, respectively. That is, analog circuit patterns, which may form elements for converting electronic signals into voltage signals may be formed on the third region III of the fourth substrate 1200, and digital circuit patterns, which may form memory elements, may be formed on the fourth region IV of the fourth substrate 1200.

The second isolation pattern 1205 may include an oxide, e.g., silicon oxide.

Seventh and eighth transistors may be formed on the first region I of the fourth substrate 1200. In example embodiments, the seventh and eighth transistors may be formed on the third and fourth regions III and IV, respectively, divided by the second isolation pattern 1205 in the first region I of the fourth substrate 1200.

Particularly, the seventh transistor may be formed by forming a seventh gate electrode 1212 on the third region III of the fourth substrate 1200 and doping impurities into upper portions of the fourth substrate 1200 adjacent to the seventh gate electrode 1212 to form sixth impurity regions 1202. Additionally, the eighth transistor may be formed by forming an eighth gate electrode 1216 on the fourth region IV of the fourth substrate 1200 and doping impurities into upper portions of the fourth substrate 1200 adjacent to the eighth gate electrode 1216 to form seventh impurity regions 1206.

In example embodiments, the seventh transistor may be an element of circuit patterns of, e.g., an SRAM device or a DRAM device.

In example embodiments, the eighth transistor may be a source follower (SF) transistor. Additionally, a select transistor and a reset transistor may be further formed on the fourth region IV of the fourth substrate 1200.

Contact plugs, wirings and vias may be formed to be electrically connected to the seventh and eighth transistors.

FIG. 40 shows a seventh contact plug 1222, a thirteenth wiring 1232, an eighth via 1242 and a fourteenth wiring 1252 sequentially stacked on the seventh gate electrode 1212 included in the seventh transistor, an eighth contact plug 1224, a fifteenth wiring 1234, a ninth via 1244 and a sixteenth wiring 1254 sequentially stacked on the sixth impurity region 1202 included in the seventh transistor, and a ninth contact plug 1226, a seventeenth wiring 1236, a tenth via 1246 and an eighteenth wiring 1256 sequentially stacked on the eighth gate electrode 1216 included in the eighth transistor on the first region I of the fourth substrate 1200.

Additionally, a nineteenth wiring 1238, an eleventh via 1248 and a twentieth wiring 1258 may be sequentially stacked on the second region II of the fourth substrate 1200.

A ninth insulating interlayer 1260 may be formed on the second surface 1203 of the fourth substrate 1200 to cover the seventh and eighth transistors, the seventh to ninth contact plugs 1222, 1224 and 1226, the thirteenth to twentieth wirings 1232, 1252, 1234, 1254, 1236, 1256, 1238 and 1258, and the eighth to eleventh vias 1242, 1244, 1246 and 1248.

Twelfth and thirteenth vias 1276 and 1278 may be formed through an upper portion of the ninth insulating interlayer 1260 to contact upper surfaces of the eighteenth and twentieth wirings 1256 and 1258, respectively, a second adhesion layer 1280 may be formed on the ninth insulating interlayer 1260 and the twelfth and thirteenth vias 1276 and 1278, and tenth and eleventh bonding patterns 1296 and 1298 may be formed through the second adhesion layer 1280 to contact twelfth and thirteenth vias 1276 and 1278, respectively, on the first and second regions I and II of the fourth substrate 1200.

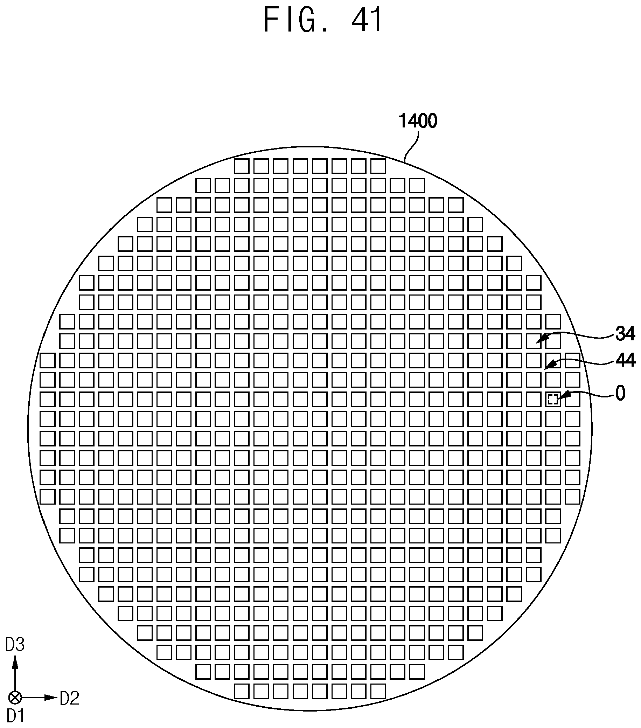

Referring to FIG. 41, a fifth substrate 1200 including a fifth chip region 34 and a fifth scribe lane region 44 may be prepared.

The fifth substrate 1400 may be a wafer substantially similar to the third substrate 1100. Thus, the fifth substrate 1400 may be a wafer including a semiconductor material, e.g., silicon, germanium, silicon-germanium, etc., and may have a circular shape in a plan view. Additionally, the fifth chip region 34 and the fifth scribe lane region 44 included in the fifth substrate 1400 may have layouts substantially similar to the layouts of the third chip region 30 and the third scribe lane region 40, respectively, included in the third substrate 1100.

Referring to FIG. 42, the fifth chip region 34 of the fifth substrate 1400 may include first and second regions I and II, which may be a pixel region and a connection region, respectively, correspondingly to the third chip region 30 of the third substrate 1100.

Referring to FIG. 43, a pixel division structure 1410, an eighth impurity region 1420 and a light sensing element 1430 (e.g., a photodiode) may be formed in the first region I of the fifth substrate 1400 including first and second surfaces 11401 and 403 opposite to each other in the first direction DI, and a transfer gate (TG) 1440 and a floating diffusion (FD) region 1450 may be formed.

In example embodiments, p-type well doped with p-type impurities, e.g., boron may be formed in the fifth substrate 1400.

The pixel division structure 1410 may extend in the first direction DI from the second surface 1403 toward the first surface 1401 downwardly in an inside of the first region I and at a boundary between the first and second regions I and II of the fifth substrate 1400, and eighth impurity region 1420 doped with p-type impurities, e.g., boron may be formed at a portion of the fifth substrate 1400 adjacent to the pixel division structure 1410. An impurity concentration of the eighth impurity region 1420 may be higher than an impurity concentration of the p-type well.

In example embodiments, the pixel division structure 1410 may have a shape of a polygon, e.g., a rectangle, in a plan view, and thus unit pixel regions in which unit pixels are formed, which may be surrounded by the pixel division structure 1410, may be defined in the first region I of the fifth substrate 1400.

In example embodiments, the pixel division structure 1410 may include a core extending in the first direction DI and a shell covering a sidewall of the core. The core may include undoped polysilicon or doped polysilicon, and the shell may include an insulating material, e.g., silicon oxide, silicon nitride, etc.

The light sensing element 1430 may be formed by doping n-type impurities, e.g., phosphorus into the p-type well in the first region I of the fifth substrate 1400.

The TG 1440 may be formed by forming a second trench extending in the first direction DI from the second surface 1403 of the fifth substrate 1400 downwardly, and filling a conductive material in the second trench to protrude from the second surface 1403 of the fifth substrate 1400 upwardly.

The TG 1440 may include a filling portion extending from the second surface 1403 of the fifth substrate 1400 downwardly in the first direction DI, and a protrusion portion on the filling portion that has an upper surface higher than the second surface 1403 of the fifth substrate 1400. In example embodiments, the TG 1440 may be formed in the unit pixel region defined by the pixel division structure 1410.

N-type impurities, e.g., phosphorus may be doped into an upper portion of the fifth substrate 1400 adjacent to the TG 1440 to form the FD region 1450.

Referring to FIG. 44, contact plugs, wirings and vias electrically connected to the TG 1440 and the FD region 1450 may be formed.

FIG. 44 shows a tenth contact plug 1466, a twenty-first wiring 1476, a fourteenth via 1486 and a twenty-second wiring 1496 sequentially stacked on the FD region 1450, and an eleventh contact plug 1468, a twenty-third wiring 1478, a fifteenth via 1488 and a twenty-fourth wiring 1498 sequentially stacked on the TG 1440 on the first region I of the fifth substrate 1400.

One or ones of the wirings, e.g., the twenty-fourth wiring 1498 may extend from the first region I of the fifth substrate 1400 to the second region II of the fifth substrate 1400.

A tenth insulating interlayer 1500 may be formed on the second surface 1403 of the fifth substrate 1400 to cover the TG 1440, the FD region 1450, the tenth and eleventh contact plugs 1466 and 1468, the twenty-first to twenty-fourth wirings 1476, 1496, 1478 and 1498, and the fourteenth to fifteenth vias 1486 and 1488.

Sixteenth and seventeenth vias 1516 and 1518 may be formed through an upper portion of the tenth insulating interlayer 1500 to contact upper surfaces of the twenty-second and twenty-fourth wirings 1496 and 1498, respectively, a third adhesion layer 1520 may be formed on the tenth insulating interlayer 1500 and the sixteenth and seventeenth vias 1516 and 1518, and twelfth and thirteenth bonding patterns 1536 and 1538 may be formed through the third adhesion layer 1520 to contact the sixteenth and seventeenth vias 1516 and 1518, respectively, on the first and second regions I and II, respectively, of the fifth substrate 1400.

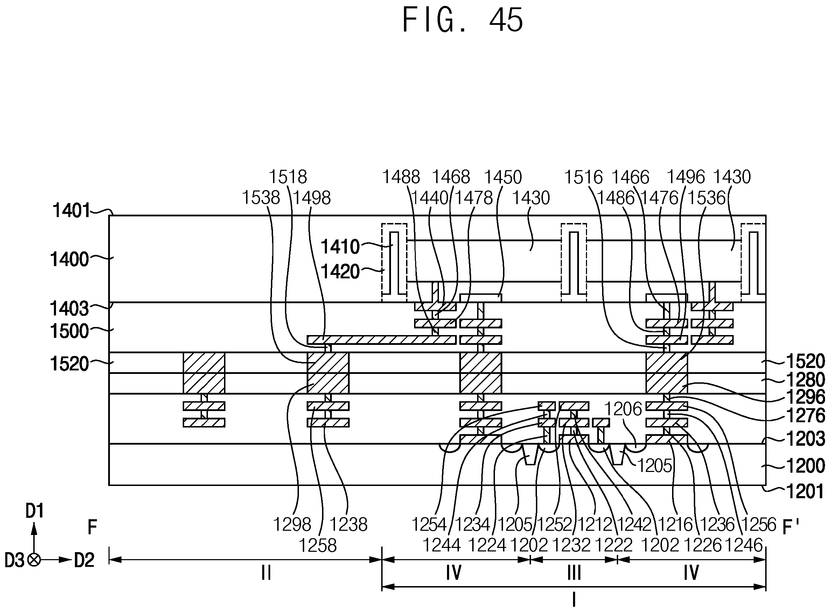

Referring to FIG. 45, processes substantially the same as or similar to those illustrated with reference to FIGS. 23 to 28 may be performed so that the fourth and fifth substrates 1200 and 1400 may be bonded with each other

In an example embodiment, the fifth substrate 1400 may be divided into a plurality of portions, a plurality of dicing processes may be performed to separate the plurality of portions of the fifth substrate 1400, respectively, and each of the plurality of portions of the fifth substrate 1400 separated from the fifth substrate 1400 may be turned over and bonded with a corresponding portion of the fourth substrate 1200.

The twelfth and thirteenth bonding patterns 1536 and 1538 on the fifth substrate 1400 may contact the tenth and eleventh bonding patterns 1296 and 1298, respectively, on the fourth substrate 1200. Thus, the FD region 1450 on the fifth substrate 1400 and electrically connected to the sixteenth via 1516 may be electrically connected to the sixth transistor on the fourth substrate 1200 through the tenth and twelfth bonding patterns 1296 and 1536.

Alternatively, the fourth substrate 1200 may be divided into a plurality of portions, and a dicing process may be performed to separate the plurality of portions of the fourth substrate 1200, and may be turned over and bonded with corresponding portions, respectively, of the fifth substrate 1400.

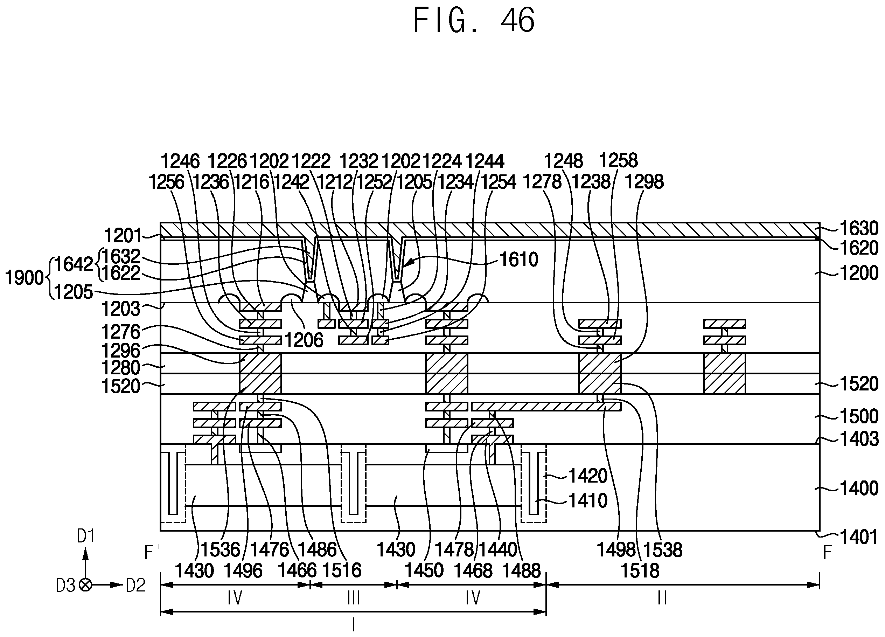

Referring to FIG. 46, the bonded fourth and fifth substrates 1200 and 1400 may be turned over, and an upper portion of the first region I of the fourth substrate 1200, that is, a portion of the first region I of the fourth substrate 1200 adjacent to the first surface 1201 may be removed to form a fourth opening 1610 exposing an upper surface of the second isolation pattern 1205.

A second insulation layer 1620 may be formed on the upper surface of the second isolation pattern 1205 exposed by the fourth opening 1610, a sidewall of the fourth opening 1610 and the first surface 1201 of the fourth substrate 1200, and a second conductive layer 1630 including, e.g., a metal may be formed on the second insulation layer 1620 to fill the fourth opening 1610.

Hereinafter, portions of the second insulation layer 1620 and the second conductive layer 1630 in the fourth opening 1610 may be referred to as a second insulation pattern 1622 and a second conductive pattern 1632, respectively, which may form a third isolation pattern structure 1642. Additionally, the second isolation pattern 1205 and the third isolation pattern structure 1642 stacked in the first direction DI in the first region I of the fourth substrate 1200 may be referred to as a second isolation structure 1900.

The third and fourth regions III and IV of the first region I of the fourth substrate 1200 may be separated from each other by the second isolation structure 1900 in the first region I of the fourth substrate 1200.

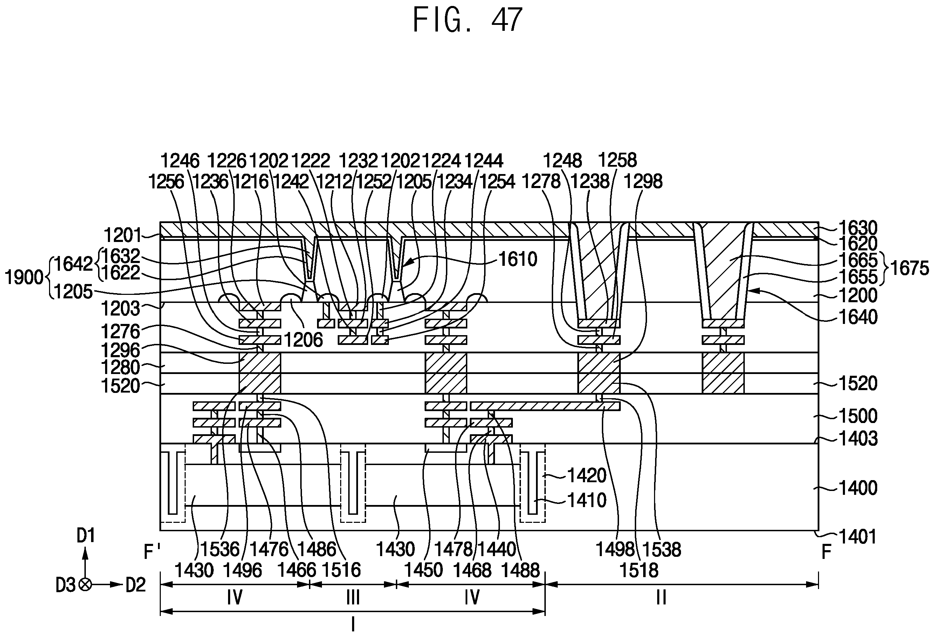

Referring to FIG. 47, a fifth opening 1640 may be formed through portions of the second conductive layer 1630 and the second insulation layer 1620 on the second region II of the fourth substrate 1200, that is, on the first surface 1201 of the fourth substrate 1200 and upper portions of the fourth substrate 1200 and the ninth insulating interlayer 1260 to expose an upper surface of the nineteenth wiring 1238.

A third insulation layer may be formed on the upper surface of the nineteenth wiring 1238 exposed by the fifth opening 1640, a sidewall of the fifth opening 1640 and an upper surface of the second conductive layer 1630, and may be partially removed by an anisotropic etching process. Thus, a third insulation pattern 1655 may be formed on the sidewall of the fifth opening 1640. The third insulation pattern 1655 may include a metal oxide, e.g., aluminum oxide, hafnium oxide, etc., or silicon oxide, e.g., Tetraethyl orthosilicate (TEOS).

A third conductive layer may be formed on the upper surface of the nineteenth wiring 1238, a sidewall and an upper surface of the third insulation pattern 1655 and the upper surface of the second conductive layer 1630 to fill the fifth opening 1640, and may be planarized until the upper surface of the second conductive layer 1630 is exposed. Thus, a third conductive pattern 1665 filling a remaining portion of the fifth opening 1640 may be formed. The third conductive pattern 1665 may include a metal, e.g., tungsten, copper, aluminum, etc.

The third insulation pattern 1655 and the third conductive pattern 1665 may form a through electrode structure 1675.

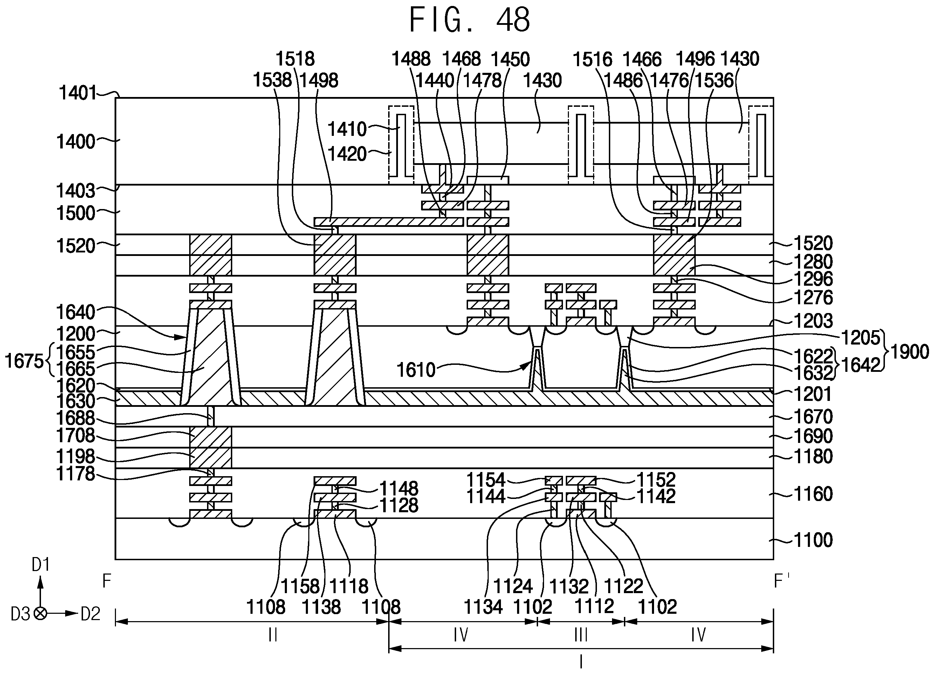

Referring to FIG. 48, an eleventh insulating interlayer 1670 may be formed on the second conductive layer 1630 and the through electrode structure 1675, and an eighteenth via 1688 may be formed through the eleventh insulating interlayer 1670 to contact the third conductive pattern 1665.

A fourth adhesion layer 1690 may be formed on the eleventh insulating interlayer 1670 and the eighteenth via 1688, and a fourteenth bonding pattern 1708 may be formed through the fourth adhesion layer 1690 to contact the eighteenth via 1688.

Processes substantially the same as or similar to those illustrated with reference to FIGS. 23 to 28 may be performed so that the third and fourth substrates 1100 and 1200 may be bonded with each other.

In an example embodiment, the bonded fourth and fifth substrates 1200 and 1400 may be divided into a plurality of portions, a plurality of dicing processes may be performed to separate the plurality of portions of the bonded fourth and fifth substrates 1200 and 1400, and each of the plurality of portions of the bonded fourth and fifth substrates 1200 and 1400 separated from the bonded fourth and fifth substrates 1200 and 1400 may be turned over and bonded with a corresponding portion of the third substrate 1100.

The fourteenth bonding pattern 1708 on the fourth substrate 1200 may contact the ninth bonding pattern 1198 on the third substrate 1100.

Alternatively, the third substrate 1100 may be divided into a plurality of portions, a plurality of dicing processes may be performed to separate the plurality of portions of the third substrate 1100, and each of the plurality of portions of the third substrate 1100 separated from the third substrate 1100 may be turned over and bonded with a corresponding portion of the fourth substrate 1200.

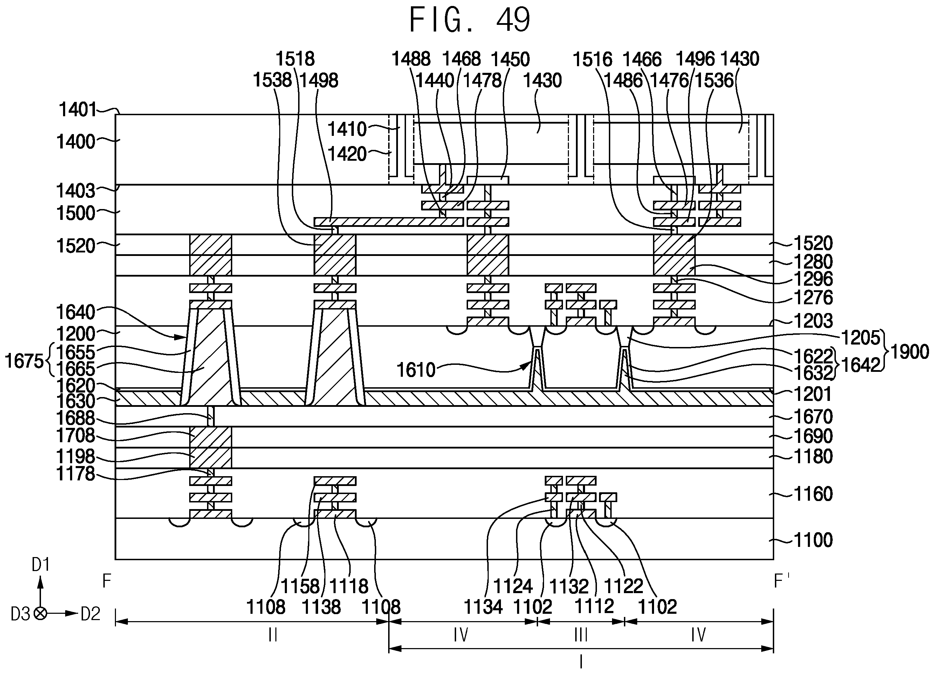

Referring to FIG. 49, an upper portion of the fifth substrate 1400, that is, a portion of the fifth substrate 1400 adjacent to the first surface 1401 of the fifth substrate 1400 may be removed.

Thus, an upper surface of the pixel division structure 1410 may be exposed, and as a result, the pixel division structure 1410 may extend through the fifth substrate 1400.

In example embodiments, the upper portion of the fifth substrate 1400 may be removed by, e.g., a grinding process or a planarization process such as a CMP process.

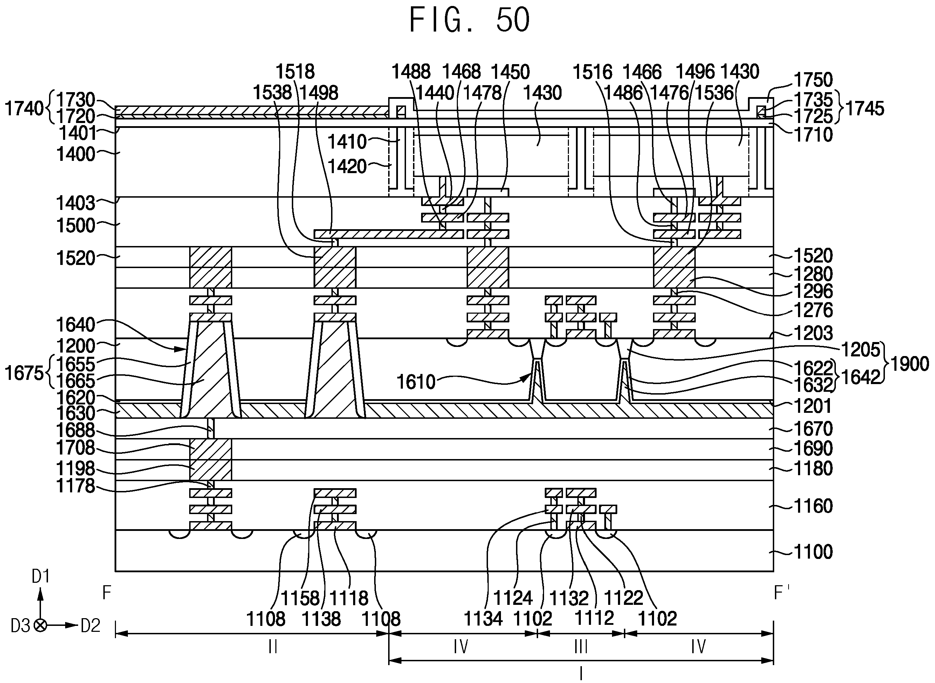

Referring to FIG. 50, a lower planarization layer 1710 may be formed on the first surface 1401 of the fifth substrate 1400 and the pixel division structure 1410.

In an example embodiment, the lower planarization layer 1710 may include first, second, third, fourth and fifth layers sequentially stacked in the first direction DI. The first to fifth layers may include, e.g., aluminum oxide, hafnium oxide, silicon oxide, silicon nitride and hafnium oxide, respectively.

A barrier layer and a fourth conductive layer may be sequentially formed on an upper surface of the lower planarization layer 1710, and portions of the fourth conductive layer and the barrier layer in the first region I may be patterned to form a second interference blocking pattern 1735 and a first interference blocking pattern 1725, respectively, and portions of the barrier layer and the fourth conductive layer in the second region II may remain as a barrier pattern 1720 and a fourth conductive pattern 1730, respectively.

The barrier layer may include, e.g., a metal nitride, and the fourth conductive layer may include, e.g., a metal.

The barrier pattern 1720 and the fourth conductive pattern 1730 may form a light blocking metal layer 1740, and the first and second interference blocking patterns 1725 and 1735 may form an interference blocking structure 1745.

A protection layer 1750 may be formed on the lower planarization layer 1710 and the interference blocking structure 1745 in the first region I. The protection layer 1750 may include a metal oxide, e.g., aluminum oxide.

Referring to FIGS. 51 and 52, a color filter array layer including color filters 1760 may be formed on the protection layer 1750 in the first region I.

In example embodiments, the color filters 1760 may be formed by depositing a color filter layer on the protection layer 1750 and the light blocking metal layer 1740 through, e.g., a spin coating process, and performing an exposure process and a developing process on the color filter layer. In an example embodiment, each of the color filters 1760 may be formed on each of the unit pixel regions defined by the pixel division structure 1410. Alternatively, each of the color filters 1760 may be formed on neighboring ones of the unit pixel regions.

A lower surface and a sidewall of each of the color filters 1760 may be covered by the protection layer 1750. For example, the color filters 1760 may include a green filter G, a blue filter B and a red filter R, however, example embodiments are not limited thereto.

An upper planarization layer 1770 may be formed on the color filter array layer, the protection layer 1750 and the light blocking metal layer 1740, and a patterning process and a reflow process may be performed on the upper planarization layer 1770 in the first region I to form a microlens 1775. The microlens 1775 and the upper planarization process 1770 may include, e.g., a photoresist material having a high transmittance.

A transparent protection layer 1780 may be formed on the microlens 1775 and the upper planarization layer 1770. The transparent protection layer 1780 may include, e.g., SO, SOC, SC, SiCN, etc.

By the above processes, the fabrication of the CIS may be completed.

When the fourth and fifth substrates 1200 and 1400 are bonded with each other and when the third and fourth substrates 1100 and 1200 are bonded with each other, processes substantially the same as or similar to those illustrated with reference to FIGS. 23 to 28 may be performed, however, example embodiments are not limited thereto.

For example, when the fourth and fifth substrates 1200 and 1400 are bonded with each other, the fourth and fifth substrates 1200 and 1400 may be entirely bonded with each other by a single process, and when the third and fourth substrates 1100 and 1200 are bonded with each other, one of the third and fourth substrates 1100 and 1200, e.g., the third substrate 1100 may be divided into a plurality of portions. Additionally, a plurality of dicing processes may be performed so as to separate the plurality of portions of the third substrate 1100, and may be bonded with corresponding portions of the other one of the third and fourth substrates 1100 and 1200, e.g., the fourth substrate 1200.

Alternatively, when the fourth and fifth substrates 1200 and 1400 are bonded with each other, one of the fourth and fifth substrates 1200 and 1400 may be divided into a plurality of portions. Additionally, a plurality of dicing processes may be performed so as to separate the plurality of portions of the one of the fourth and fifth substrates 1200 and 1400, and may be bonded with corresponding portions of the other one of the fourth and fifth substrates 1200 and 1400.

While aspects of example embodiments have been particularly shown and described, it will be understood by one of ordinary skill in the art that variations in form and detail may be made therein without departing from the scope of the claims.

## Claims

1. A method of manufacturing a semiconductor device, the method comprising:
forming, on a first wafer (100, 1200), a first structure including first chip regions (10, 32) and a first scribe lane region (20, 42) surrounding the first chip regions;
forming, on a second wafer (700, 1400), a second structure including second chip regions (15, 34) and a second scribe lane region (25, 44) surrounding the second chip regions;
separating a first part (900) of the second wafer (700, 1400) by a first dicing process, the first part of the second wafer including first ones of the second chip regions (15, 34) in the central portion of the second wafer in a plan view, the first dicing process being performed along a portion of the second scribe lane region surrounding the first part;
bonding the first part (900) of the second wafer (700, 1400) with the first wafer (100, 1200);
separating at least one second part (910, 920, 930) of the second wafer (700, 1400) by a second dicing
process, each of the at least one second part (910, 920, 930) including second ones of the second chip regions (15, 34) in at least one edge portion of the second wafer (700, 1400) in a plan view, the second ones of the second chip regions (15, 34) being other than the first ones of the second chip regions (15, 34), the second dicing process being performed along a portion of the second scribe lane region surrounding each of the at least one second part; bonding the at least one second part (910, 920, 930) of the second wafer (700, 1400) with the first wafer (100, 1200) thereby bonding the second ones of the second chip regions (15, 34) with the first wafer (100, 1200);
separating the first wafer (100, 1200) bonded with the first part (900) and the at least one
second part (910, 920, 930) of the second wafer (700, 1400) into a plurality of chips each including one of the first chip regions (10, 32) of the first wafer and one of the second chip regions (15, 34) of the second wafer by a third dicing process,
wherein a warpage occurrence probability of the central portion of the second wafer (700) is lower than a warpage occurrence probability of the at least one edge portion of the second wafer (700), and the central portion of the second wafer (700) includes a greater number of second chip regions (15) than the at least one edge portion of the second wafer (700),
wherein the number of the first ones of the second chip regions (15, 34) in the first part (900) of the second wafer (700, 1400) is greater than the number of the second ones of the second chip regions (15, 34) in each of the at least one second part (910, 920, 930) of the second wafer (700, 1400).

2. The method of claim 1, wherein the bonding of the first ones of the second chip regions (15, 34) with the first wafer (100, 1200) is such that the first ones of the second chip regions (15, 34) of the second wafer (700, 1400) are aligned with corresponding ones of the first chip regions (10, 32) of the first wafer (100, 1200).

3. The method of claim 2, wherein the bonding the second ones of the second chip regions (15, 34) with the first wafer (100, 1200) is such that the second ones of the second chip regions (15, 34) of the second wafer (700, 1400) are aligned with corresponding ones of the first chip regions (10, 32) of the first wafer (100, 1200).

4. The method of claim 2 or 3, wherein a first bonding pattern is disposed on each of the first chip regions (10, 32), and a second bonding pattern is disposed on each of the second chip regions (15, 34), each of the first and second bonding pattern including a metal, and wherein the bonding the first ones of the second chip regions (15, 34) of the second wafer (700, 1400) with the first wafer (100, 1200) is such that the first and second bonding patterns contact each other.

5. The method of claim 4, wherein the bonding the second ones of the second chip regions (15, 34) of the second wafer (700, 1400) with the first wafer (100, 1200) is such that the first and second bonding patterns contact each other.

6. The method of any one of claims 1 to 5, wherein the method further comprises, prior to the third dicing process:
forming a third structure on a third wafer (1100) including third chip regions (30) and a third scribe lane region (40) surrounding the third chip regions;
separating a third part of a third wafer (1100) by a fourth dicing process, the third part of the third wafer (1100) including third ones of third chip regions (30) in a central portion of the third wafer (1100) in a plan view, the fourth dicing process performed along a portion of a third scribe lane region (40) surrounding the third part, the third wafer (1100) including the third chip regions (30) and the third scribe lane region (40) surrounding the third chip regions (30);
bonding the third part of the third wafer (1100) with parts of the second wafer (1400) which are bonded with the first wafer (100, 1200) thereby bonding the third ones of the third chip regions (30) with the parts of the second wafer (1400); separating at least one fourth part of the third wafer by a fifth dicing process, each of the at least one fourth part including fourth ones of the third chip regions (30) in at least one edge portion of the third wafer (1100) in a plan view, the fifth dicing process performed along a portion of the third scribe lane region (40) surrounding each of the at least one fourth part; bonding the at least one fourth part of the third wafer (1100) with the parts of the second wafer (1400) thereby bonding fourth ones of the third chip regions (30) with the second wafer (1400).

7. The method of claim 6, wherein each of the first chip regions (32) comprises elements for converting electronic signals into voltage signals, wherein each of the second chip regions (34) comprises pixels of an image sensor, and wherein each of the third chip regions (30) comprises a logic device.

8. The method of any one of claims 1 to 7, further comprising:
a memory channel structure (490) on each of the first chip regions (10) extending in a vertical direction substantially perpendicular to an upper surface of the first wafer (100); and a gate electrode structure including gate electrodes (402, 404, 406) spaced apart from each other in the vertical direction on each of the first chip regions (10), each of the gate electrodes (402, 404, 406) surrounding the memory channel structure (490).

9. The method of claim 8, further comprising:
a transistor on each of he second chip regions (15); and
a wiring on each of the second chip regions (15) that is electrically connected to the transistor.

## Patentansprüche

1. Verfahren zur Herstellung einer Halbleitervorrichtung, wobei das Verfahren Folgendes umfasst:
Bilden, auf einem ersten Wafer (100, 1200), einer ersten Struktur, die erste Chipbereiche (10, 32) und einen ersten Scribe-Lane-Bereich (20, 42) einschließt, der die ersten Chipbereiche umgibt;
Bilden, auf einem zweiten Wafer (700, 1400), einer zweiten Struktur, die zweite Chipbereiche (15, 34) und einen zweiten Scribe-Lane-Bereich (25, 44) einschließt, der die zweiten Chipbereiche umgibt;
Abtrennen eines ersten Teils (900) des zweiten Wafers (700,1400) durch einen ersten Chipschneideprozess, wobei der erste Teil des zweiten Wafers die ersten der zweiten Chipbereiche (15, 34) im zentralen Abschnitt des zweiten Wafers in einer Draufsicht einschließt, wobei der erste Chipschneideprozess entlang eines Abschnitts des zweiten Scribe-Lane-Bereichs durchgeführt wird, der den ersten Teil umgibt;
Bonden des ersten Teils (900) des zweiten Wafers (700, 1400) mit dem ersten Wafer (100, 1200);
Abtrennen von mindestens einem zweiten Teil (910, 920, 930) des zweiten Wafers (700, 1400) durch einen zweiten Chipschneideprozess, wobei jeder des mindestens einen zweiten Teils (910, 920, 930) zweite der zweiten Chipbereiche (15, 34) in mindestens einem Randabschnitt des zweiten Wafers (700, 1400) in einer Draufsicht einschließt, wobei die zweiten der zweiten Chipbereiche (15, 34) andere sind als die ersten der zweiten Chipbereiche (15, 34), wobei der zweite Chipschneideprozess entlang eines Abschnitts des zweiten Scribe-Lane-Bereichs durchgeführt wird, der jeden des mindestens einen zweiten Teils umgibt; Bonden des mindestens einen zweiten Teils (910, 920, 930) des zweiten Wafers (700, 1400) mit dem ersten Wafer (100, 1200), wodurch die zweiten der zweiten Chipbereiche (15, 34) mit dem ersten Wafer (100, 1200) gebondet werden;
Abtrennen des ersten Wafers (100, 1200), der mit dem ersten Teil (900) und mindestens einem zweiten Teil (910, 920, 930) des zweiten Wafers (700, 1400) gebondet ist, in eine Vielzahl von Chips, von denen jeder einen der ersten Chipbereiche (10, 32) des ersten Wafers und einen der zweiten Chipbereiche (15, 34) des zweiten Wafers einschließt, durch einen dritten Chipschneideprozess,
wobei die Wahrscheinlichkeit des Auftretens einer Verformung im zentralen Abschnitt des zweiten Wafers (700) geringer ist als die Wahrscheinlichkeit des Auftretens einer Verformung im mindestens einen Randabschnitt des zweiten Wafers (700), und wobei der zentrale Abschnitt des zweiten Wafers (700) eine größere Anzahl von zweiten Chipbereichen (15) einschließt als der mindestens eine Randabschnitt des zweiten Wafers (700),
wobei die Anzahl der ersten der zweiten Chipbereiche (15, 34) im ersten Teil (900) des zweiten Wafers (700, 1400) größer ist als die Anzahl der zweiten der zweiten Chipbereiche (15, 34) in jedem des mindestens einen zweiten Teils (910, 920, 930) des zweiten Wafers (700, 1400).

2. Verfahren nach Anspruch 1, wobei das Bonden der ersten der zweiten Chipbereiche (15, 34) mit dem ersten Wafer (100, 1200) so erfolgt, dass die ersten der zweiten Chipbereiche (15, 34) des zweiten Wafers (700, 1400) mit den entsprechenden der ersten Chipbereiche (10, 32) des ersten Wafers (100, 1200) ausgerichtet sind.

3. Verfahren nach Anspruch 2, wobei das Bonden der zweiten der zweiten Chipbereiche (15, 34) mit dem ersten Wafer (100, 1200) so erfolgt, dass die zweiten der zweiten Chipbereiche (15, 34) des zweiten Wafers (700, 1400) mit den entsprechenden der ersten Chipbereiche (10, 32) des ersten Wafers (100, 1200) ausgerichtet sind.

4. Verfahren nach Anspruch 2 oder 3, wobei auf jedem der ersten Chipbereiche (10, 32) ein erstes Bondingmuster angeordnet ist und auf jedem der zweiten Chipbereiche (15, 34) ein zweites Bondingmuster angeordnet ist, wobei jedes des ersten und zweiten Bondingmusters ein Metall einschließt, und wobei das Bonden der ersten der zweiten Chipbereiche (15, 34) des zweiten Wafers (700, 1400) mit dem ersten Wafer (100, 1200) so erfolgt, dass sich die ersten und zweiten Bondingmuster berühren.

5. Verfahren nach Anspruch 4, wobei das Bonden der zweiten der zweiten Chipbereiche (15, 34) des zweiten Wafers (700, 1400) mit dem ersten Wafer (100, 1200) so erfolgt, dass sich die ersten und zweiten Bondingmuster berühren.

6. Verfahren nach einem der Ansprüche 1 bis 5, wobei das Verfahren vor dem dritten Chipschneideprozess weiter Folgendes umfasst:
Bilden einer dritten Struktur auf einem dritten Wafer (1100), der dritte Chipbereiche (30) und einen dritten Scribe-Lane-Bereich (40) einschließt, der die dritten Chipbereiche umgibt;
Abtrennen eines dritten Teils eines dritten Wafers (1100) durch einen vierten Chipschneideprozess, wobei der dritte Teil des dritten Wafers (1100) in einer Draufsicht dritte der dritten Chipbereiche (30) in einem zentralen Abschnitt des dritten Wafers (1100) einschließt, wobei der vierte Chipschneideprozess entlang eines Abschnitts eines dritten Scribe-Lane-Bereichs (40) durchgeführt wird, der den dritten Teil umgibt, wobei der dritte Wafer (1100) die dritten Chipbereiche (30) und den dritten Scribe-Lane-Bereich (40), der die dritten Chipbereiche (30) umgibt, einschließt;
Bonden des dritten Teils des dritten Wafers (1100) mit Teilen des zweiten Wafers (1400), die mit dem ersten Wafer (100, 1200) gebondet sind, wodurch die dritten der dritten Chipbereiche (30) mit den Teilen des zweiten Wafers (1400) gebondet werden; Abtrennen von mindestens einem vierten Teil des dritten Wafers durch einen fünften Chipschneideprozess, wobei jeder des mindestens einen vierten Teils vierte der dritten Chipbereiche (30) in mindestens einem Randabschnitt des dritten Wafers (1100) in einer Draufsicht einschließt, wobei der fünfte Chipschneideprozess entlang eines Abschnitts des dritten Scribe-Lane-Bereichs (40) durchgeführt wird, der jedes des mindestens einen vierteil Teils umgibt; Bonden des mindestens einen vierten Teils des dritten Wafers (1100) mit den Teilen des zweiten Wafers (1400), wodurch vierte der dritten Chipbereiche (30) mit dem zweiten Wafer (1400) gebondet werden.

7. Verfahren nach Anspruch 6, wobei jeder der ersten Chipbereiche (32) Elemente zur Umwandlung elektronischer Signale in Spannungssignale umfasst, wobei jeder der zweiten Chipbereiche (34) Pixel eines Bildsensors umfasst und wobei jeder der dritten Chipbereiche (30) eine Logikvorrichtung umfasst.

8. Verfahren nach einem der Ansprüche 1 bis 7, das weiter Folgendes umfasst:
eine Speicherkanalstruktur (490) auf jedem der ersten Chipbereiche (10), die sich in einer vertikalen Richtung im Wesentlichen senkrecht zu einer oberen Oberfläche des ersten Wafers (100) erstreckt; und eine Gate-Elektrodenstruktur einschließlich Gate-Elektroden (402, 404, 406), die in der vertikalen Richtung auf jedem der ersten Chipbereiche (10) voneinander beabstandet sind, wobei jede der Gate-Elektroden (402, 404, 406) die Speicherkanalstruktur (490) umgibt.

9. Verfahren nach Anspruch 8, das weiter Folgendes umfasst:
einen Transistor auf jedem der zweiten Chipbereiche (15); und
eine Verdrahtung auf jedem der zweiten Chipbereiche (15), die elektrisch mit dem Transistor verbunden ist.

## Revendications

1. Procédé de fabrication d'un dispositif semi-conducteur, le procédé comprenant :
la formation, sur une première plaquette (100, 1200), d'une première structure incluant des premières régions de puce (10, 32) et une première région de chemin de découpe (20, 42) entourant les premières régions de puce ;
la formation, sur une deuxième plaquette (700, 1400), d'une deuxième structure incluant des deuxièmes régions de puce (15, 34) et une deuxième région de chemin de découpe (25, 44) entourant les deuxièmes régions de puce ;
la séparation d'une première partie (900) de la deuxième plaquette (700,1400) par un premier processus de découpe, la première partie de la deuxième plaquette incluant des premières des deuxièmes régions de puce (15, 34) dans la partie centrale de la deuxième plaquette dans une vue en plan, le premier processus de découpe étant réalisé le long d'une partie de la deuxième région de chemin de découpe entourant la première partie ;
le collage de la première partie (900) de la deuxième plaquette (700, 1400) avec la première plaquette (100, 1200) ;
la séparation d'au moins une deuxième partie (910, 920, 930) de la deuxième plaquette (700, 1400) par un deuxième processus de découpe, chacune de la au moins une deuxième partie (910, 920, 930) incluant des deuxièmes des deuxièmes régions de puce (15, 34) dans au moins une portion de bord de la deuxième plaquette (700, 1400) en vue en plan, les deuxièmes des deuxièmes régions de puce (15, 34) étant différentes des premières des deuxièmes régions de puce (15, 34), le deuxième processus de découpe étant réalisé le long d'une portion de la deuxième région de chemin de découpe entourant chacune de la au moins une deuxième partie ; le collage de la au moins une deuxième partie (910, 920, 930) de la deuxième plaquette (700, 1400) avec la première plaquette (100, 1200) en collant ainsi les deuxièmes des deuxièmes régions de puce (15, 34) avec la première plaquette (100, 1200) ;
la séparation de la première plaquette (100, 1200) collée avec la première partie (900) et la au moins une deuxième partie (910, 920, 930) de la deuxième plaquette (700, 1400) en une pluralité de puces incluant chacune une des premières régions de puce (10, 32) de la première plaquette et une des deuxièmes régions de puce (15, 34) de la deuxième plaquette par un troisième processus de découpe,
dans lequel la probabilité d'apparition d'un gauchissement de la portion centrale de la deuxième plaquette (700) est inférieure à la probabilité d'apparition d'un gauchissement de la au moins une portion de bord de la deuxième plaquette (700), et la portion centrale de la deuxième plaquette (700) inclut un plus grand nombre de deuxièmes régions de puce (15) que la au moins une portion de bord de la deuxième plaquette (700),
dans lequel le nombre des premières des deuxièmes régions de puce (15, 34) dans la première partie (900) de la deuxième plaquette (700, 1400) est supérieur au nombre des deuxièmes des deuxièmes régions de puce (15, 34) dans chacune de la au moins une deuxième partie (910, 920, 930) de la deuxième plaquette (700, 1400).

2. Procédé selon la revendication 1, dans lequel le collage des premières des deuxièmes régions de puce (15, 34) avec la première plaquette (100, 1200) est tel que les premières des deuxièmes régions de puce (15, 34) de la deuxième plaquette (700, 1400) soient alignées avec celles correspondantes des premières régions de puce (10, 32) de la première plaquette (100, 1200).

3. Procédé selon la revendication 2, dans lequel le collage des deuxièmes des deuxièmes régions de puce (15, 34) avec la première plaquette (100, 1200) est tel que les deuxièmes des deuxièmes régions de puce (15, 34) de la deuxième plaquette (700, 1400) soient alignées avec celles correspondantes des premières régions de puce (10, 32) de la première plaquette (100, 1200).

4. Procédé selon la revendication 2 ou 3, dans lequel un premier motif de collage est disposé sur chacune des premières régions de puce (10, 32), et un deuxième motif de collage est disposé sur chacune des deuxièmes régions de puce (15, 34), chacun des premier et deuxième motifs de collage incluant un métal, et dans lequel le collage des premières des deuxièmes régions de puce (15, 34) de la deuxième plaquette (700, 1400) avec la première plaquette (100, 1200) est tel que les premier et deuxième motifs de collage entrent en contact.

5. Procédé selon la revendication 4, dans lequel le collage des deuxièmes des deuxièmes régions de puce (15, 34) de la deuxième plaquette (700, 1400) avec la première plaquette (100, 1200) est tel que les premier et deuxième motifs de collage entrent en contact.

6. Procédé selon l'une quelconque des revendications 1 à 5, dans lequel le procédé comprend en outre, avant le troisième processus de découpe :
la formation d'une troisième structure sur une troisième plaquette (1100) incluant des troisièmes régions de puce (30) et une troisième région de chemin de découpe (40) entourant les troisièmes régions de puce ;
la séparation d'une troisième partie d'une troisième plaquette (1100) par un quatrième processus de découpe, la troisième partie de la troisième plaquette (1100) incluant des troisièmes des troisièmes régions de puce (30) dans une portion centrale de la troisième plaquette (1100) en vue en plan, le quatrième processus de découpe étant réalisé le long d'une portion d'une troisième région de chemin de découpe (40) entourant la troisième partie, la troisième plaquette (1100) incluant les troisièmes régions de puce (30) et la troisième région de chemin de découpe (40) entourant les troisièmes régions de puce (30) ;
le collage de la troisième partie de la troisième plaquette (1100) avec des parties de la deuxième plaquette (1400) qui sont collées avec la première plaquette (100, 1200), en collant ainsi les troisièmes des troisièmes régions de puce (30) avec les parties de la deuxième plaquette (1400) ; la séparation d'au moins une quatrième partie de la troisième plaquette par un cinquième processus de découpe, chacun de la au moins une quatrième partie incluant des quatrièmes des troisièmes régions de puce (30) dans au moins une portion de bord de la troisième plaquette (1100) en vue en plan, le cinquième processus de découpe étant réalisé le long d'une portion de la troisième région de chemin de découpe (40) entourant chacune de la au moins une quatrième partie ; le collage de la au moins une quatrième partie de la troisième plaquette (1100) avec les parties de la deuxième plaquette (1400), en collant ainsi des quatrièmes des troisièmes régions de puce (30) avec la deuxième plaquette (1400).

7. Procédé selon la revendication 6, dans lequel chacune des premières régions de puce (32) comprend des éléments de conversion de signaux électroniques en signaux de tension, dans lequel chacune des deuxièmes régions de puce (34) comprend des pixels d'un capteur d'image, et dans lequel chacune des troisièmes régions de puce (30) comprend un dispositif logique.

8. Procédé selon l'une quelconque des revendications 1 à 7, comprenant en outre :
une structure de canal de mémoire (490) sur chacune des premières régions de puce (10) s'étendant dans une direction verticale sensiblement perpendiculaire à une surface supérieure de la première plaquette (100) ; et une structure d'électrodes de grille incluant des électrodes de grille (402, 404, 406) espacées les unes des autres dans la direction verticale sur chacune des premières régions de puce (10), chacune des électrodes de grille (402, 404, 406) entourant la structure de canal de mémoire (490).

9. Procédé selon la revendication 8, comprenant en outre :
un transistor sur chacune des deuxièmes régions de puce (15) ; et
un câblage sur chacune des deuxièmes régions de puce (15) qui est connecté électriquement au transistor.
